# EUROPEAN PATENT APPLICATION

(11) **EP 4 852 059 A1**
(43) Date of publication of application: **09.12.2026**
(21) Application number: 24922531.9
(22) Date of filing: 20.08.2024
(51) Int. Cl.: H01L 25/075, H10H 29/01, H10H 20/857, H10D 86/00

(54) **DISPLAY DEVICE AND MANUFACTURING METHOD THEREFOR**

(30) Priority: 01.02.2024 KR 20240016016
(71) Applicant: Samsung Display Co., Ltd., Yongin-si, Gyeonggi-do 17113 (KR)
(72) Inventor: HONG, Sung Chul, Yongin-si, Gyeonggi-do 17113 (KR); PYO, Ki Hyun, Yongin-si, Gyeonggi-do 17113 (KR)
(74) Representative: Marks & Clerk LLP
(86) International application number: PCT/KR2024/012329
(87) International publication number: WO 2025/164866

(57) **Abstract**

There are provided a display device and a method of manufacturing the display device. The display device includes: a substrate; and a display element layer disposed on the substrate. The display element layer includes: an anode electrode and a cathode electrode; an anode reflective electrode layer disposed on the anode electrode; a cathode reflective electrode layer disposed on the cathode electrode; a light emitting element including a first element electrode and a second element electrode; an anode transparent electrode layer electrically connecting the anode reflective electrode layer and the first element electrode to each other; and a cathode transparent electrode layer electrically connecting the cathode reflective electrode layer and the second element electrode to each other.

## Description

### Technical Field

Embodiments relate to a display device and a method of manufacturing the display device.

### Background Art

Recently, as interest in information displays has increased, research and development of display devices have been continuously conducted.

### Detailed Description of Invention

### Technical Problem

Embodiments provide a display device and a method of manufacturing the display device capable of improving light emission efficiency.

Embodiments also provide a display device and a method of manufacturing the display device capable of reducing or minimizing a risk that a voltage of an electrical signal supplied to a light emitting element drops.

Embodiments also provide a display device and a method of manufacturing the display device capable of reducing or minimizing a risk that an electrical connection defect occurs due to misalignment of a light emitting element.

However, embodiments are not limited to those set forth herein. The above and other embodiments will become more apparent to one of ordinary skill in the art to which the disclosure pertains by referencing the detailed description of the disclosure given below.

### Technical Solution

In accordance with an aspect of the disclosure, there is provided a display device including: a substrate; and a display element layer disposed on the substrate, wherein the display element layer may include: an anode electrode and a cathode electrode; an anode reflective electrode layer disposed on the anode electrode; a cathode reflective electrode layer disposed on the cathode electrode; a light emitting element including a first element electrode and a second element electrode; an anode transparent electrode layer electrically connecting the anode reflective electrode layer and the first element electrode to each other; and a cathode transparent electrode layer electrically connecting the cathode reflective electrode layer and the second element electrode to each other.

The cathode electrode may include a base cathode electrode and a bridge cathode electrode, which are integral with each other. The base cathode electrode may cover an area wider than an area which the bridge cathode electrode covers, and may overlap the light emitting element in a plan view.

The display device may include sub-pixels. The base cathode electrode may extend throughout the sub-pixels in a first direction. The anode electrode may include a plurality of anode electrodes respectively corresponding to the sub-pixels. The bridge cathode electrode may extend in a second direction different from the first direction, and be disposed between the plurality of anode electrodes in the first direction.

The anode electrode and the cathode electrode may be formed as a same layer, and include a same conductive material.

The display device may further include a bank covering a portion of each of the anode electrode and the cathode electrode, the bank having an opening. The bank may expose a portion of the base cathode electrode. The base cathode electrode and the cathode reflective electrode layer may be in contact with each other at the portion of the base cathode electrode, which the bank exposes.

The base cathode electrode and the cathode reflective electrode layer may be electrically connected to each other at a cathode contact surface. In a plan view, the cathode contact surface may overlap the light emitting element such that the cathode reflective electrode layer may form a reflective surface for the light emitting element.

The cathode contact surface may entirely cover the light emitting element in a plan view.

The anode reflective electrode layer may not be disposed on an inner side surface of the bank, which faces the opening.

The cathode reflective electrode layer and the anode reflective electrode layer may be formed as a same layer, and include a same reflective conductive material.

The cathode transparent electrode layer and the anode transparent electrode layer may be formed as a same layer, and include a same transparent conductive material.

The display element layer may be disposed on the substrate in an upper direction of the substrate. The light emitting element may include a first element electrode and a second element electrode, which face the upper direction. The anode transparent electrode layer may overlap the first element electrode in a plan view. The cathode transparent electrode layer may overlap the second element electrode in a plan view.

In a plan view, the cathode transparent electrode layer may overlap the cathode reflective electrode layer, and may not overlap the anode reflective electrode layer. In a plan view, the anode transparent electrode layer may overlap the cathode reflective electrode layer and the anode reflective electrode layer.

The display device may further include an intermediate insulating layer disposed in the opening, the intermediate insulating layer being directly adjacent to the light emitting element.

The anode transparent electrode layer and the cathode transparent electrode layer may be directly disposed on the intermediate insulating layer.

A difference between a height of a corner portion of the light emitting element and a maximum height of the intermediate insulating layer may be smaller than a minimum thickness of the anode transparent electrode layer and the cathode transparent electrode layer.

The display device may further include a capping layer covering the anode transparent electrode layer, the cathode transparent electrode layer, and the light emitting element.

The display device may further include an identification pattern formed in at least one of the cathode electrode and the cathode reflective electrode layer.

The identification pattern may include an engraved pattern or an embossed pattern.

The anode electrode may be in contact with the anode reflective electrode layer at an anode contact surface. The cathode electrode may be in contact with the cathode reflective electrode layer at a cathode contact surface. The anode contact surface may entirely overlap the light emitting element in a plan view.

In accordance with another aspect of the disclosure, there is provided a method of manufacturing a display device, the method including: manufacturing a pixel circuit layer disposed on a substrate; and manufacturing a display element layer on the pixel circuit layer, wherein the manufacturing the display element layer may include: patterning an anode electrode and a cathode electrode on the pixel circuit layer; patterning a bank to form an opening; patterning a reflective electrode layer including a cathode reflective electrode layer electrically connected to the anode electrode and an anode reflective electrode layer electrically connected to the cathode electrode; patterning an intermediate insulating layer disposed in the opening; disposing a light emitting element in the opening; and patterning a transparent electrode layer including a cathode transparent electrode layer electrically connected to the cathode reflective electrode layer and an anode transparent electrode layer electrically connected to the anode reflective electrode layer.

The cathode electrode may include a base cathode electrode and a bridge cathode electrode, which are integral with each other. The base cathode electrode may cover an area wider than an area which the bridge cathode electrode covers, and may overlap the light emitting element in a plan view.

The base cathode electrode and the cathode reflective electrode layer may be electrically connected to each other at a cathode contact surface. In a plan view, the cathode contact surface may entirely cover the light emitting element such that the cathode reflective electrode layer may form a reflective surface for the light emitting element.

The patterning of the intermediate insulating layer may include: providing the intermediate insulating layer in the opening; and etching a portion of the intermediate insulating layer, using a halftone mask.

The light emitting element may include a lateral chip type light emitting element. The patterning of the transparent electrode layer may include disposing the anode transparent electrode layer and the cathode transparent electrode layer to be directly adjacent to the intermediate insulating layer.

### Advantageous Effects

In accordance with the disclosure, there may be provided a display device and a method of manufacturing a display device, in which light emission efficiency may be improved.

In accordance with the disclosure, there may be provided a display device and a method of manufacturing a display device, in which a risk that the voltage of an electrical signal supplied to a light emitting element drops may be reduced.

In accordance with the disclosure, there may be provided a display device and a method of manufacturing a display device, in which a risk that an electrical connection defect occurs due to misalignment of a light emitting element may be reduced.

### Description of Drawings

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey the scope of the example embodiments to those skilled in the art.
FIG. 1 is a schematic block diagram illustrating an embodiment of a display device.
FIG. 2 is a schematic block diagram illustrating an embodiment of any one of sub-pixels shown in FIG. 1.
FIG. 3 is a schematic plan view illustrating an embodiment of a display panel shown in FIG. 1.
FIG. 4 is a schematic cross-sectional view illustrating an embodiment of the display panel shown in FIG. 3.
FIG. 5 is a schematic cross-sectional view illustrating another embodiment of the display panel shown in FIG. 3.
FIG. 6 is a schematic plan view illustrating pixels in accordance with an embodiment.
FIGS. 7 and 8 are schematic plan views illustrating a pixel in accordance with an embodiment.
FIG. 9 is a schematic cross-sectional view illustrating a sub-pixel in accordance with an embodiment.
FIG. 10 is a schematic cross-sectional view illustrating a light emitting element in accordance with an embodiment.
FIG. 11 is a schematic cross-sectional view illustrating pixels in accordance with an embodiment.
FIG. 12 is a schematic cross-sectional view illustrating a sub-pixel in accordance with another embodiment.
FIGS. 13 and 14 are schematic plan views illustrating an identification pattern in accordance with an embodiment.
FIG. 15 is a schematic flowchart illustrating a method of manufacturing a display device in accordance with an embodiment.
FIG. 16 is a schematic flowchart illustrating a step of manufacturing a display element layer in accordance with an embodiment.
FIGS. 17 to 22 are schematic plan views illustrating process steps of the method of manufacturing the display device in accordance with an embodiment.
FIGS. 23 to 31 are schematic cross-sectional views illustrating process steps of the method of manufacturing the display device in accordance with an embodiment.
FIG. 32 is a schematic block diagram illustrating an embodiment of a display system.
FIGS. 33 to 36 are schematic perspective views illustrating application examples of the display system shown in FIG. 32.

### Modes of the Invention

Hereinafter, embodiments will be described in more detail with reference to the accompanying drawings. In the description below, only a necessary part to understand an operation according to the disclosure is described and the descriptions of other parts are omitted in order not to unnecessarily obscure subject matters of the disclosure. For example, the disclosure is not limited to embodiments described herein, but may be embodied in various different forms. Rather, embodiments described herein are provided to thoroughly and completely describe the disclosed contents and to sufficiently transfer the ideas of the disclosure to a person of ordinary skill in the art.

In the entire specification, when an element is referred to as being "connected" or "coupled" to another element, it can be directly connected or coupled to the another element or be indirectly connected or coupled to the another element with one or more intervening elements interposed therebetween. The technical terms used herein are used only for the purpose of illustrating a specific embodiment and not intended to limit the embodiment. It will be understood that when a component "includes" an element, unless there is another opposite description thereto, it should be understood that the component does not exclude another element but may further include another element. It will be understood that for the purposes of this disclosure, "at least one of X, Y, and Z" can be construed as X only, Y only, Z only, or any combination of two or more items X, Y, and Z (e.g., XYZ, XYY, YZ, ZZ). Similarly, for the purposes of this disclosure, "at least one selected from the group consisting of X, Y, and Z" can be construed as X only, Y only, Z only, or any combination of two or more items X, Y, and Z (e.g., XYZ, XYY, YZ, ZZ).

It will be understood that, although the terms "first", "second," etc. may be used herein to describe various elements, these elements should not be limited by these terms. These terms are only used to distinguish one element from another element. Thus, a "first" element discussed below could also be termed a "second" element without departing from the teachings of the disclosure.

Spatially relative terms, such as "below," "above," and the like, may be used herein for ease of description to describe the relationship of one element to another element, as illustrated in the figures. It will be understood that the spatially relative terms, as well as the illustrated configurations, are intended to encompass different orientations of the apparatus in use or operation in addition to the orientations described herein and depicted in the figures. For example, if the apparatus in the figures is turned over, elements described as "below" or "beneath" other elements or features would then be oriented "above" the other elements or features. Thus, the term, "above," may encompass both an orientation of above and below. The apparatus may be otherwise oriented (e.g., rotated 90 degrees or at other orientations) and the spatially relative descriptors used herein interpreted accordingly.

For example, the embodiments of the disclosure are described here with reference to schematic diagrams of ideal embodiments (and an intermediate structure) of the disclosure, so that changes in a shape as shown due to, for example, manufacturing technology and/or a tolerance may be expected. Therefore, the embodiments shall not be limited to the specific shapes of a region shown here, but include shape deviations caused by, for example, the manufacturing technology. The regions shown in the drawings are schematic in nature, and the shapes thereof do not represent the actual shapes of the regions of the device, and do not limit the scope of the disclosure.

The disclosure generally relates to a display device and a method of manufacturing a display device. Hereinafter, a display device and a method of manufacturing a display device in accordance with an embodiment will be described with reference to the accompanying drawings.

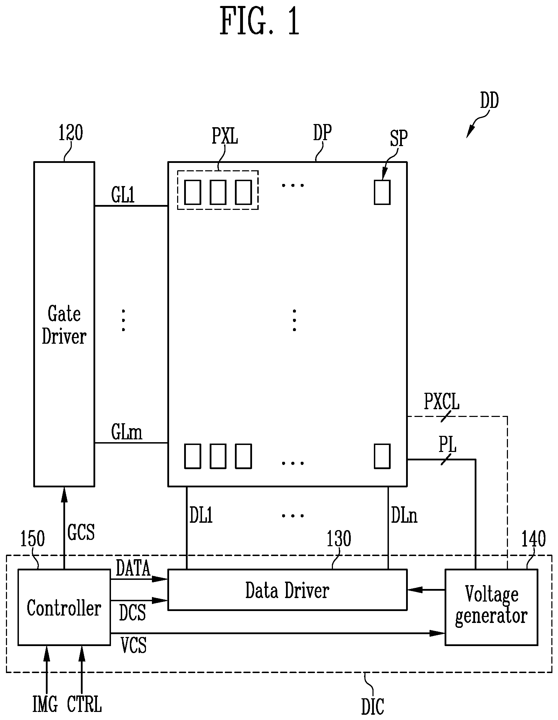

FIG. 1 is a schematic block diagram illustrating an embodiment of a display device.

Referring to FIG. 1, the display device 100 may include a display panel DP, a gate driver 120, a data driver 130, a voltage generator 140, and a controller 150.

The display panel DP may include sub-pixels SP. The sub-pixels SP may be connected to the gate driver 120 through first to m-th gate lines GL1 to GLm. The sub-pixels SP may be connected to the data driver 130 through first to n-th data lines DL1 to DLn.

The sub-pixels SP may generate light of two or more colors. For example, each of the sub-pixels SP may generate light of red, green, blue, cyan, magenta, yellow, white, and the like.

Two or more sub-pixels among the sub-pixels SP may constitute (or form) a pixel PXL. For example, the pixel PXL may include three sub-pixels as shown in FIG. 1. For example, the pixel PXL may emit lights of various colors with various luminances according to a combination of lights emitted from the sub-pixels included therein.

The gate driver 120 may be connected to the sub-pixels SP arranged in a row direction through the first to m-th gate lines GL1 to GLm. The gate driver 120 may output gate signals to the first to m-th gate lines GL1 to GLm in response to a gate control signal GCS. In embodiments, the gate control signal GCS may include a start signal indicating a start of each frame, a horizontal synchronization signal, and the like.

The gate driver 120 may be disposed at a side of the display panel DP. However, embodiments are not limited thereto. For example, the gate driver 120 may be divided into two or more drivers which are physically and/or logically divided, and these drivers may be disposed at a side of the display panel DP and the other side of the display panel DP, which is opposite to the side. For example, in some embodiments, the gate driver 120 may be disposed in various forms at the periphery of the display panel DP.

The data driver 130 may be connected to the sub-pixels SP arranged in a column direction through the first to n-th data lines DL1 to DLn. The data driver 130 may receive image data DATA and a data control signal DCS from the controller 150. The data driver 130 may operate in response to the data control signal DCS. In embodiments, the data control signal DCS may include a source start pulse, a source shift clock, a source output enable signal, and the like.

The data driver 130 may receive voltages from the voltage generator 140. The data driver 130 may apply data signals having grayscale voltages corresponding to the image data DATA to the first to n-th data lines DL1 to DLn by using the received voltages. In a case that a gate signal is applied to each of the first to m-th gate lines GL1 to GLm, data signals corresponding to the image data DATA may be applied to the first to n-th data line DL1 to DLm. Accordingly, corresponding sub-pixels SP may generate light corresponding to the data signals. Accordingly, an image may be displayed on the display panel DP.

In embodiments, the gate driver 120 and the data driver 130 may include complementary metal-oxide semiconductor (CMOS) circuit elements.

The voltage generator 140 may operate in response to a voltage control signal VCS from the controller 150. The voltage generator 140 may generate a plurality of voltages and provide the generated voltages to components of the display device 100. The voltage generator 140 may generate a plurality of voltages by receiving an input voltage from the outside of the display device 100 and regulating the received voltage.

The voltage generator 140 may generate a first power voltage and a second power voltage. The generated first and second power voltages may be provided to the sub-pixels SP through power lines PL. In other embodiments, at least one of the first and second power voltages may be provided from the outside of the display device 100.

Besides, the voltage generator 140 may provide various voltages and/or signals. For example, the voltage generator 140 may provide one or more initialization voltages applied to the sub-pixels SP. For example, in a sensing operation for sensing electrical characteristics of transistors and/or light emitting elements of the sub-pixels SP, a predetermined reference voltage may be applied to the first to n-th data lines DL1 to DLn, and the voltage generator 140 may generate the reference voltage and transfer the reference voltage to the data driver 130. For example, in a display operation for displaying an image on the display panel DP, common pixel control signals may be applied to the sub-pixels SP, and the voltage generator 140 may generate the pixel control signals. In embodiments, the voltage generator 140 may provide the pixel control signals to the sub-pixels SP through pixel control lines PXCL. In FIG. 1, it is illustrated that the pixel control lines PXCL are connected between the voltage generator 140 and the display panel DP. However, embodiments are not limited thereto. For example, the pixel control lines PXCL may be connected between the gate driver 120 and the display panel DP. The pixel control signals may be transferred to the sub-pixels SP from the gate driver 120 through the pixel control lines PXCL.

The controller 150 may control overall operations of the display device 100. The controller 150 may receive, from the outside, input image data IMG and a control signal CTRL for controlling the input image data IMG. The controller 150 may provide the gate control signal GCS, the data control signal DCS, and the voltage control signal VCS in response to the control signal CTRL.

The controller 150 may convert the input image data IMG to be suitable for the display device 100 or the display panel DP, thereby outputting the image data DATA. In embodiments, the controller 150 may align the input image data IMG to be suitable for the sub-pixels SP in units of rows, thereby outputting the image data DATA.

Two or more components among the data driver 130, the voltage generator 140, and the controller 150 may be mounted on an integrated circuit. As shown in FIG. 1, the data driver 130, the voltage generator 140, and the controller 150 may be included in a driver integrated circuit DIC. The data driver 130, the voltage generator 140, and the controller 150 may be components functionally divided in a driver integrated circuit DIC. In other embodiments, at least one of the data driver 130, the voltage generator 140, and the controller 150 may be provided as a component distinguished from the driver integrated circuit DIC.

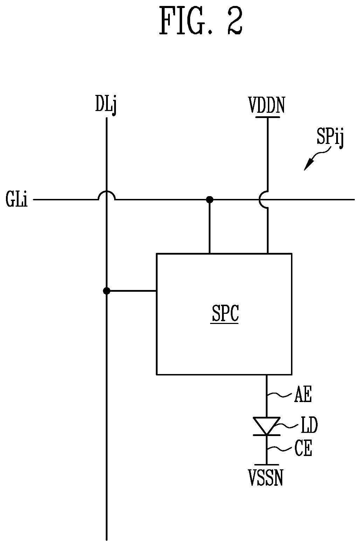

FIG. 2 is a schematic block diagram illustrating an embodiment of any one of the sub-pixels shown in FIG. 1. In FIG. 2, a sub-pixel SPij arranged on an i-th row (i is an integer which is greater than or equal to 1 and is smaller than or equal to m) and a j-th column (j is an integer which is greater than or equal to 1 and is smaller than or equal to n) among the sub-pixels SP shown in FIG. 1 is exemplarily illustrated.

Referring to FIG. 2, the sub-pixel SPij may include a sub-pixel circuit SPC and a light emitting element LD.

The light emitting element LD may be connected between a first power voltage node VDDN and a second power voltage node VSSN. The first power voltage node VDDN may be connected to one of the power lines PL shown in FIG. 1, to receive a first power voltage. The second power voltage node VSSN may be connected to another one of the power lines PL, to receive a second power voltage. The first power voltage may have a voltage level higher than a voltage level of the second power voltage.

The light emitting element LD may be connected between an anode electrode AE and a cathode electrode CE. The anode electrode AE may be connected to the first power voltage node VDDN through the sub-pixel circuit SPC. For example, the anode electrode AE may be connected to the first power voltage node VDDN through one or more transistors included in the sub-pixel circuit SPC. The cathode electrode CE may be connected to the second power voltage node VSSN. The light emitting element LD may emit light according to a current flowing from the anode electrode AE to the cathode electrode CE.

The sub-pixel circuit SPC may be connected to an i-th gate line GLi among the first to m-th gate lines GL1 to GLm shown in FIG. 1 and a j-th data line DLj among the first to n-th data lines DL1 to DLn shown in FIG. 1. In response to a gate signal received through the i-th gate line GLi, the sub-pixel circuit SPC controls the light emitting element LD to emit light according to a data signal received through the j-th data line DLj. In embodiments, the sub-pixel circuit SPC may be further connected to the pixel control lines PXCL shown in FIG. 1. The sub-pixel circuit SPC may control the light emitting element LD in further response to control signals received through the pixel control lines PXCL.

For these operations, the sub-pixel circuit SPC may include circuit elements, e.g., transistors and one or more capacitors.

The transistors of the sub-pixel circuit SPC may include P-type transistors and/or N-type transistors. In embodiments, the transistors of the sub-pixel circuit SPC may include a Metal Oxide Silicon Field Effect Transistor (MOSFET). In embodiments, the transistors of the sub-pixel circuit SPC may include an amorphous silicon semiconductor, a monocrystalline silicon semiconductor, polycrystalline silicon semiconductor, an oxide semiconductor, and the like.

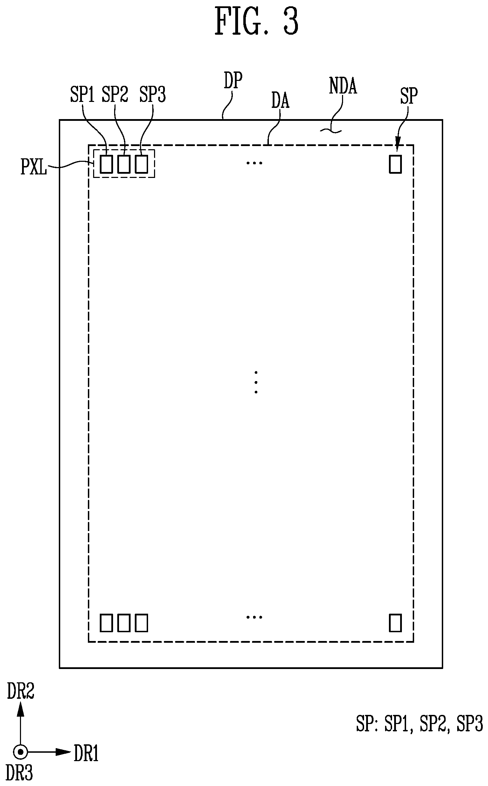

FIG. 3 is a schematic plan view illustrating an embodiment of the display panel shown in FIG. 1.

Referring to FIG. 3, a display panel DP may include a display area DA and a non-display area NDA. The display panel DP may display an image through the display area DA. The non-display area NDA may be disposed at the periphery of the display area DA.

The display panel DP may include sub-pixels SP in the display area DA. The sub-pixels SP may be arranged in a first direction DR1 and a second direction DR2 intersecting the first direction DR1. For example, the sub-pixels SP may be arranged in a matrix form along the first direction DR1 and the second direction DR2. In another example, the sub-pixels SP may be arranged in a zigzag form along the first direction DR1 and the second direction DR2. The arrangement of the sub-pixels SP may vary in some embodiments. The first direction DR1 may be a row direction, and the second direction DR2 may be a column direction.

Two or more sub-pixels among the sub-pixels SP may form a pixel PXL. In FIG. 3, it is illustrated that the pixel PXL includes three sub-pixels SP1 to SP3. However, embodiments are not limited thereto. For example, the pixel PXL may include two sub-pixels. Hereinafter, for convenience of description, it is assumed that the pixel PXL includes first to third sub-pixels SP1 to SP3.

Each of the first to third sub-pixels SP1 to SP3 may generate light of one of various colors such as red, green, blue, cyan, magenta, and yellow. Hereinafter, for clear and simple description, it is assumed that the first sub-pixel SP1 generates light of a red color, the second sub-pixel SP2 generates light of a green color, and the third sub-pixel SP3 generates light of a blue color.

Each of the first to third sub-pixels SP1 to SP3 may include at least one light emitting element that generates light. In embodiments, light emitting elements of the first to third sub-pixels SP1 to SP3 may generate light of a same color. For example, the light emitting elements of the first to third sub-pixels SP1 to SP3 may generate light of a blue color. In other embodiments, the light emitting elements of the first to third sub-pixels SP1 to SP3 may generate light of different colors. For example, the light emitting elements of the first to third sub-pixels SP1 to SP3 may generate light of a red color, a green color, and a blue color, respectively.

Self-luminous display panels, such as a light emitting diode display panel (LED display panel) using a light emitting diode of micro scale or nano scale as a light emitting element, may be used as the display panel DP.

Components for controlling the sub-pixels SP may be disposed in the non-display area NDA. Lines connected to the sub-pixels SP, e.g., the first to m-th gate lines GL1 to GLm, the first to n-th data lines DL1 to DLn, the power lines PL, and the pixel control lines PXCL, which are shown in FIG. 1, may be disposed in the non-display area NDA.

At least one of the gate driver 120, the data driver 130, the voltage generator 140, and the controller 150, which are shown in FIG. 1, may be disposed in the non-display area NDA of the display panel DP. In embodiments, the gate driver 120 may be disposed in the non-display area NDA. The data driver 130, the voltage generator 140, and the controller 150 may be implemented as the driver integrated circuit DIC shown in FIG. 1, which is distinguished from the display panel DP, and the driver integrated circuit DIC may be connected to the lines disposed in the non-display area NDA. In other embodiments, the gate driver 120, the data driver 130, the voltage generator 140, and the controller 150 may be implemented as an integrated circuit distinguished from the display panel DP.

In embodiments, the display area DA may have various shapes. The display area DA may have a closed-loop shape including linear sides and/or curved sides. For example, the display area DA may have shapes such as a polygon, a circle, a semicircle, and an ellipse.

In embodiments, the display panel DP may have a flat display surface. In other embodiments, the display panel DP may at least partially have a round display surface. In embodiments, the display panel DP may be bendable, foldable, or rollable. The display panel DP and/or a substrate of the display panel DP may include materials having flexibility.

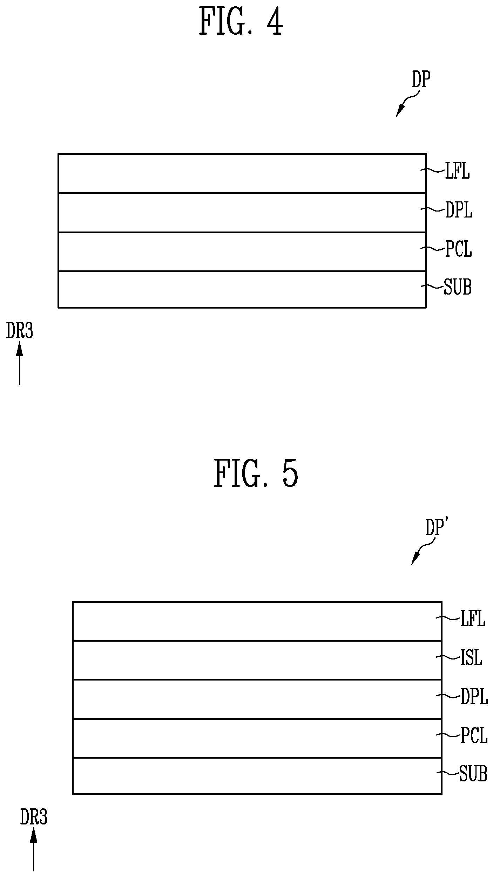

FIG. 4 is a schematic cross-sectional view illustrating an embodiment of the display panel shown in FIG. 3.

Referring to FIG. 4, a display panel DP may include a substrate SUB, and a pixel circuit layer PCL, a display element layer DPL, and a light functional layer LFL, which are sequentially stacked in a third direction DR3 intersecting the first and second directions DR1 and DR2 on the substrate SUB.

The substrate SUB may be made of an insulative material such as glass or resin. For example, the substrate SUB may include a glass substrate. In another example, the substrate SUB may include polyimide (PI) substrate. In still another example, the substrate SUB may include a silicon wafer substrate formed by a semiconductor process.

In embodiments, the substrate SUB may be made of a material having flexibility to be curvable or foldable, and have a single-layer structure or a multi-layer structure. For example, the material having flexibility may include at least one of polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, and cellulose acetate propionate. However, embodiments are not limited thereto.

The pixel circuit layer PCL may be disposed on the substrate SUB. The pixel circuit layer PCL may include insulating layers, and semiconductor patterns and conductive patterns, which are disposed between the insulating layers. The conductive patterns of the pixel circuit layer PCL may function as circuit elements, lines, and the like.

The circuit elements of the pixel circuit layer PCL may include the sub-pixel circuit SPC (see FIG. 2) of each of the sub-pixels SP shown in FIG. 3. For example, the circuit elements of the pixel circuit layer PCL may be provided (or formed) as transistors and one or more capacitors of the sub-pixel circuit SPC.

The lines of the pixel circuit layer PCL may include lines connected to each of the sub-pixels SP. The lines of the pixel circuit layer PCL may include various signal lines and/or various voltage lines, which are necessary for driving the display element layer DPL.

The display element layer DPL may be disposed on the pixel circuit layer PCL. The display element layer DPL may include light emitting elements of the sub-pixels SP.

The light functional layer LFL may be disposed on the display element layer DPL. The light functional layer LFL may include light conversion patterns having color conversion particles and/or light scattering particles. For example, color conversion particles may include quantum dots. The quantum dots may change a wavelength (or color) of light emitted from the display element layer DPL. In embodiments, the light conversion patterns may be omitted.

The light functional layer LFL may further include a color filter layer including color filters. The color filter may selectively transmit light having a specific wavelength (or specific color) therethrough. In embodiments, the color filter layer may be omitted.

A window for protecting an exposed surface (or top surface) of the display panel DP may be provided (or disposed) on the light functional layer LFL. The window may protect the display panel DP from external impact. The window may be bonded to the light functional layer LFL through an optically transparent adhesive (or cohesive) member. The window may have a multi-layer structure selected from a glass substrate, a plastic film, and a plastic substrate. This multi-layer structure may be formed by a continuous process or an adhesive process using an adhesive layer. The whole or a portion of the window may have flexibility.

FIG. 5 is a schematic cross-sectional view illustrating another embodiment of the display panel shown in FIG. 3.

Referring to FIG. 5, a display panel DP' may include a substrate SUB, a pixel circuit layer PCL, a display element layer DPL, an input sensing layer ISL, and a light functional layer LFL. The substrate SUB, the pixel circuit layer PCL, the display element layer DPL, and the light functional layer LFL are formed identically to the substrate SUB, the pixel circuit layer PCL, the display element layer DPL, and the light functional layer LFL, which are described with reference to FIG. 4, respectively. Hereinafter, redundant descriptions will be omitted for descriptive convenience.

The input sensing layer ISL may sense a user input with respect to a top surface (or display surface) of the display panel DP'. The input sensing layer ISL may include components suitable for sensing an external object such as a hand of a user or a pen. For example, the input sensing layer ISL may include touch electrodes.

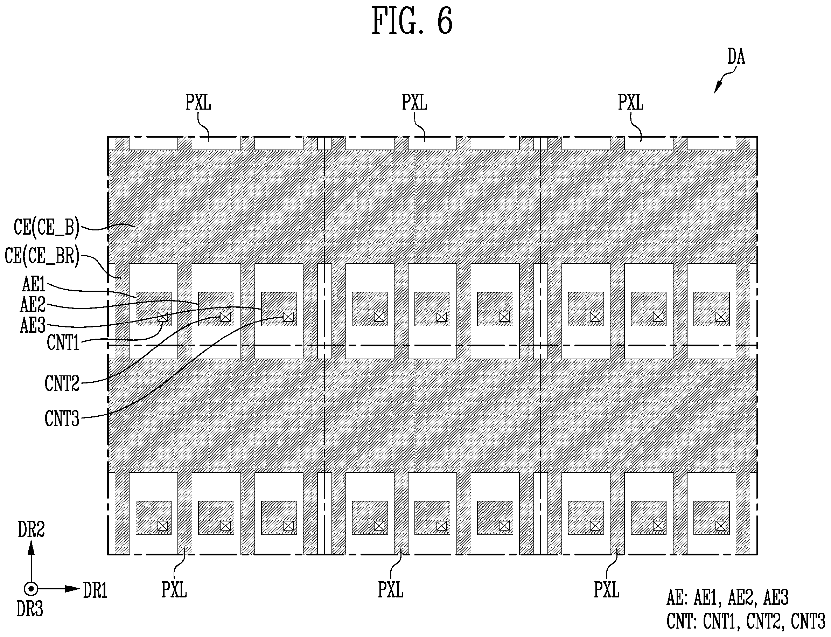

Hereinafter, a display device DD including a display panel DP in accordance with an embodiment will be described with reference to FIGS. 6 to 14. In FIGS. 6 to 14, portions overlapping those described above will be briefly described or will not be repeated for descriptive convenience.

FIG. 6 is a schematic plan view illustrating pixels in accordance with an embodiment. FIG. 6 schematically illustrates pixels PXL adjacent to each other in a display area DA.

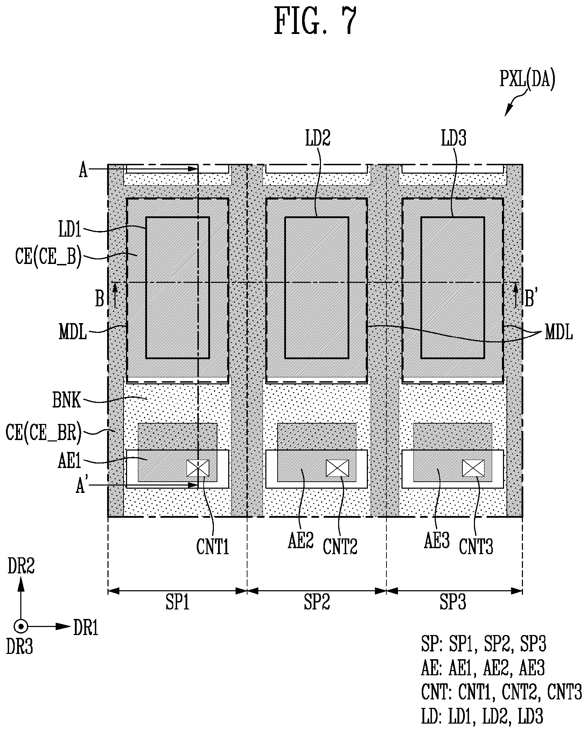

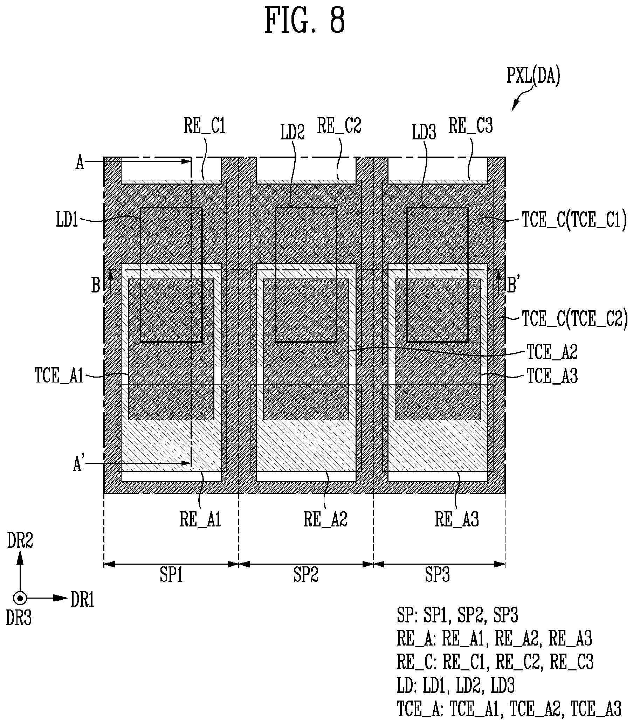

FIGS. 7 and 8 are schematic plan views illustrating a pixel in accordance with an embodiment. FIGS. 7 and 8 schematically illustrate any one of the pixels PXL. FIGS. 7 and 8 respectively illustrate components disposed in a same area of the display area DA. Referring to FIGS. 7 and 8, an arrangement relationship on a plane between components disposed in an area will be clearly understood.

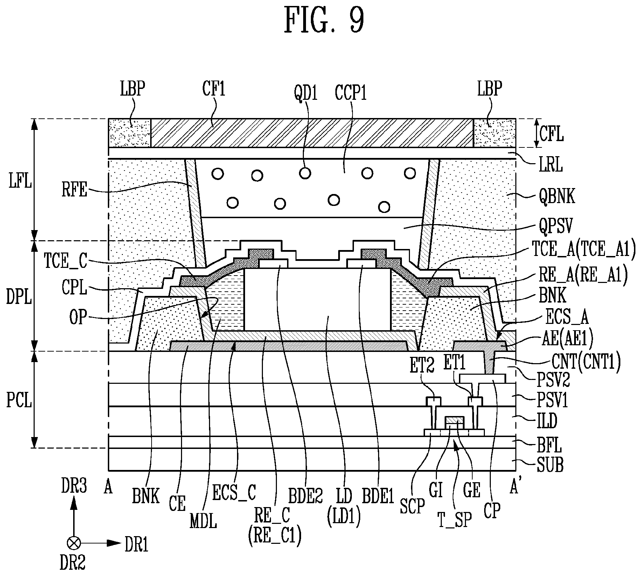

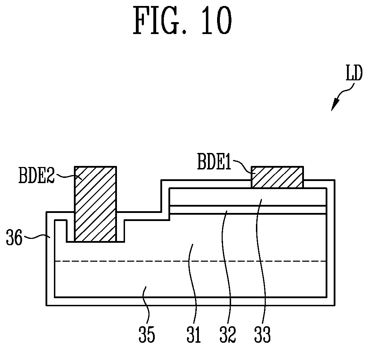

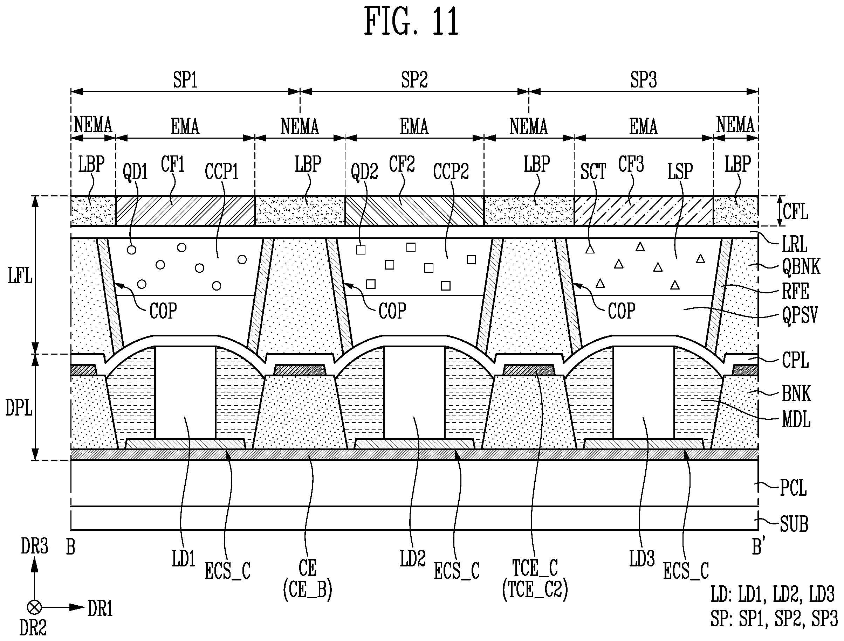

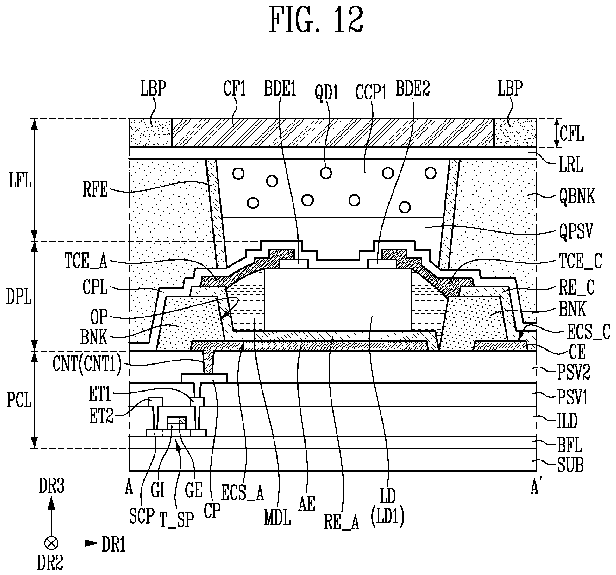

FIG. 9 is a schematic cross-sectional view illustrating a sub-pixel in accordance with an embodiment. FIG. 9 is a schematic cross-sectional view taken along line A-A' shown in FIGS. 7 and 8. FIG. 10 is a schematic cross-sectional view illustrating a light emitting element in accordance with an embodiment. FIG. 11 is a schematic cross-sectional view illustrating pixels in accordance with an embodiment. FIG. 11 is a schematic cross-sectional view taken along line B-B' shown in FIGS. 7 and 8. FIG. 12 is a schematic cross-sectional view illustrating a sub-pixel in accordance with another embodiment.

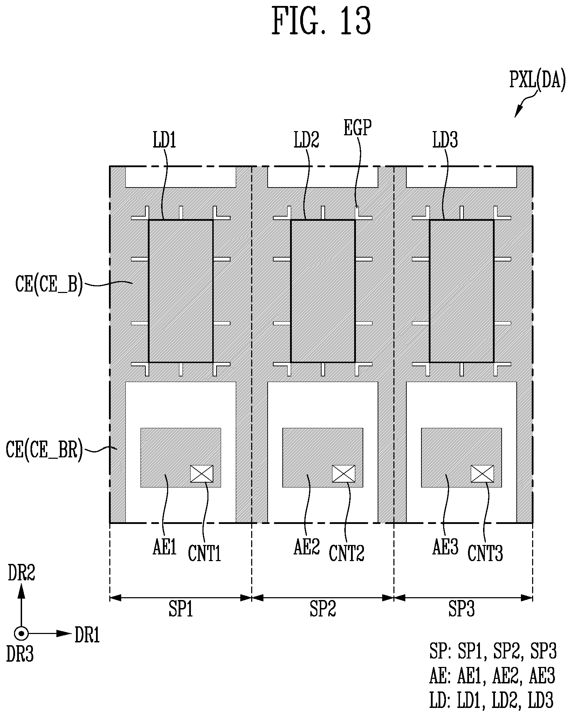

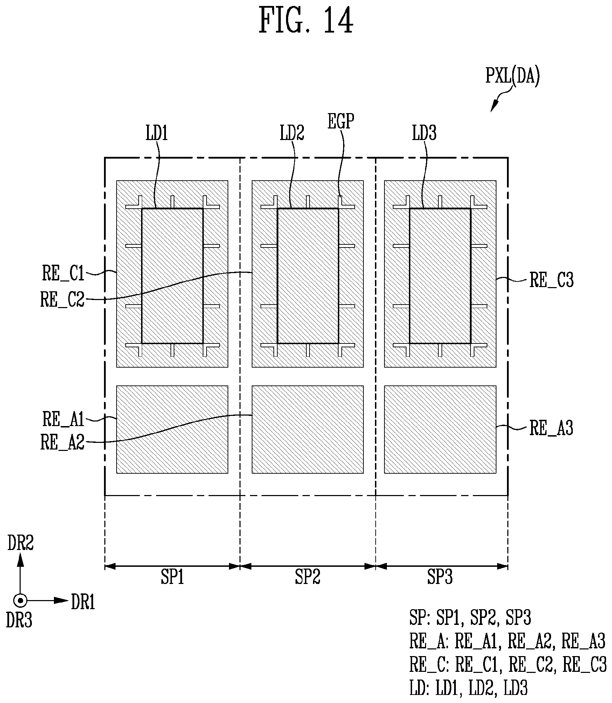

FIGS. 13 and 14 are schematic plan views illustrating an identification pattern in accordance with an embodiment. For convenience of description, FIGS. 13 and 14 schematically illustrate an area corresponding to the above-described planar structure.

Referring to FIG. 6, pixels PXL in the display area DA may be adjacent to each other along the first direction DR1 and the second direction DR2.

In some embodiments, at least some of electrodes included in each of the pixels PXL may be connected (e.g., electrically connected) to each other.

The pixels PXL (or the display device DD) may include anode electrode AE and a cathode electrode CE, and further include a contact portion CNT.

The anode electrode AE and the cathode electrode CE may be disposed in (or formed as) a same layer, and include a same conductive material. In some embodiments, the anode electrode AE and the cathode electrode CE may include a transparent conductive material. For example, the transparent conductive material may include at least one selected from the group consisting of silver nano wire (AgNW), Indium Tin Oxide (ITO), Indium Zinc Oxide (IZO), Indium Gallium Zinc Oxide (IGZO), Antimony Zinc Oxide (AZO), Indium Tin Zinc Oxide (ITZO), Zinc Oxide (ZnO), Tin Oxide (SnO2), carbon nano tube, and graphene. However, embodiments are not limited thereto.

The anode electrode AE and the cathode electrode CE may be electrically separated from each other in the display area DA. For example, the anode electrode AE and the cathode electrode CE may be formed by a same process, and be physically spaced apart from each other.

The anode electrode AE and the cathode electrode CE may be defined in each of the pixels PXL. For example, at least a portion of the cathode electrode CE may be disposed in each of the pixels PXL, and at least a portion of the anode electrode AE may be disposed in each of the pixels PXL.

The anode electrode AE may include a first anode electrode AE1, a second anode electrode AE2, and a third anode electrode AE3. The first anode electrode AE1, the second anode electrode AE2, and the third anode electrode AE3 may be included in each of the pixels PXL.

The first anode electrode AE1, the second anode electrode AE2, and the third anode electrode AE3 may be spaced apart from each other. The first anode electrode AE1 may be included in a first sub-pixel SP1. The second anode electrode AE2 may be included in a second sub-pixel SP2. The third anode electrode AE3 may be included in a third sub-pixel SP3.

Each of the first anode electrode AE1, the second anode electrode AE2, and the third anode electrode AE3 may have an isolated island shape, and be surrounded by the cathode electrode CE. The first anode electrode AE1, the second anode electrode AE2, and the third anode electrode AE3 may be sequentially disposed along the first direction DR1.

The anode electrode AE may be connected (e.g., electrically connected) to a circuit element of a pixel circuit layer PCL through the contact portion CNT. The contact portion CNT may overlap the anode electrode AE in a plan view. The contact portion CNT may include a first contact portion CNT1 which is connected (e.g., electrically connected) to the first anode electrode AE1 and is used to form the first sub-pixel SP1, a second contact portion CNT2 which is connected (e.g., electrically connected) to the second anode electrode AE2 and is used to form the second sub-pixel SP2, and a third contact portion CNT3 which is connected (e.g., electrically connected) to the third anode electrode AE3 and is used to form the third sub-pixel SP3.

The cathode electrode CE may include a base cathode electrode CE_B and a bridge cathode electrode CE_BR, which are integral with each other. The base cathode electrode CE_B may be disposed (or extend) throughout the pixels PXL in the first direction DR1. For example, a portion of the base cathode electrode CE_B may form a cathode electrode CE of a pixel PXL, and another portion of the base cathode electrode CE_B may form a cathode electrode CE of another pixel PXL.

The base cathode electrode CE_B and the bridge cathode electrode CE_BR may be integral with each other, and be connected (e.g., electrically connected) to each other. The base cathode electrode CE_B and the bridge cathode electrode CE_BR may form a potential corresponding to the second power voltage.

The base cathode electrode CE_B may have a wide and flat shape. For example, the base cathode electrode CE_B may cover a wide area in the pixel PXL, and have a width greater than a width of the bridge cathode electrode CE_BR and the anode electrode AE.

The bridge cathode electrode CE_BR may have a narrow width. For example, the bridge cathode electrode CE_BR may be disposed between anode electrodes AE adjacent to each other (e.g., adjacent to each other in the first direction DR1).

In some embodiments, the cathode electrode CE may be arranged in a mesh form, and accordingly, a cathode connection structure may be formed, which supplies an electrical signal having a cathode potential to each of the pixels PXL. For example, a portion of the cathode electrode CE may extend in the first direction DR1, and another portion of the cathode electrode CE may extend in the second direction DR2. For example, the base cathode electrode CE_B may extend in the first direction DR1, and the bridge cathode electrode CE_BR may extend in the second direction DR2.

In some embodiments, a cathode signal may be supplied to a light emitting element LD through the base cathode electrode CE_B. As described above, the base cathode electrode CE_B may form an extended area. Accordingly, a risk that the cathode electrode CE has an excessively increased resistance may be reduced, and thus a risk that the voltage of an electrical signal supplied to the light emitting element LD drops may be reduced.

Hereinafter, a structure for forming the display device DD in accordance with an embodiment will be described with reference to FIGS. 7 to 11.

Referring to FIGS. 7 to 11, the pixel PXL may include first to third sub-pixels SP1 to SP3. The first to third sub-pixels SP1 to SP3 may be arranged in various manners. For example, the first to third sub-pixels SP1 to SP3 may be sequentially arranged along the first direction DR1. However, embodiments are not limited thereto.

The pixel PXL (or the display device DD) may include layers disposed adjacent to a light emitting element LD. For example, the pixel PXL (or the display device DD) may include an anode electrode AE, a contact portion CNT, a cathode electrode CE, a bank BNK, an intermediate insulating layer MDL, a reflective electrode layer RE_A and RE_C, and transparent electrode layers TCE_A and TCE_C.

The anode electrode AE may be disposed adjacent to the cathode electrode CE. For example, the anode electrode AE may be adjacent to a portion of the cathode electrode CE in the second direction DR2. A first anode electrode AE1 may overlap a portion of a base cathode electrode CE_B overlapping the first sub-pixel SP1 along the second direction DR2. A second anode electrode AE2 may overlap a portion of the base cathode electrode CE_B overlapping the second sub-pixel SP2 along the second direction DR2. A third anode electrode AE3 may overlap a portion of the base cathode electrode CE_B overlapping the third sub-pixel SP3 along the second direction DR2. For example, the anode electrode AE may be adjacent to another portion of the cathode electrode CE in the first direction DR1. Each of the first to third anode electrodes AE1 to AE3 may be disposed between bridge cathode electrodes CE_BR adjacent to each other in the first direction DR1.

The anode electrode AE may overlap the bank BNK in a plan view. At least a portion of the anode electrode AE may be exposed by the bank BNK in a plan view.

The plane defined in this specification may be a plane extending in a first direction DR1 and a second direction DR2, and may be defined with respect to a plane on which a substrate SUB is disposed. In some embodiments, the third direction DR3 may be a thickness direction of the substrate SUB. The third direction DR3 may be a light emission direction of the display device DD.

In some embodiments, the contact portion CNT electrically connecting the anode electrode AE and a circuit element of the pixel circuit layer PCL to each other may not overlap the bank BNK in a plan view. However, embodiments are not limited thereto. In some embodiments, the contact portion CNT may overlap the bank BNK in a plan view.

In some embodiments, the anode electrode AE may be spaced apart from the intermediate insulating layer MDL. For example, the anode electrode AE may not overlap the intermediate insulating layer MDL in a plan view. For example, the anode electrode AE may be spaced apart from the intermediate insulating layer MDL in the second direction DR2 in a plan view.

In some embodiments, the anode electrode AE may be spaced apart from the light emitting element LD. For example, the anode electrode AE may not overlap the light emitting element LD in a plan view. For example, the anode electrode AE may be spaced apart from the light emitting element LD in the second direction DR2 in a plan view.

The cathode electrode CE may overlap the bank BNK in a plan view. In some embodiments, at least a portion of the cathode electrode CE may be exposed by the bank BNK. For example, a portion of the base cathode electrode CE_B may be covered by the bank BNK, and a portion of the base cathode electrode CE_B may be exposed by the bank BNK. The bridge cathode electrode CE_BR may be covered by the bank BNK. In some embodiments, the bridge cathode electrode CE_BR may be covered (e.g., entirely covered) by the bank BNK.

In some embodiments, the cathode electrode CE may overlap the intermediate insulating layer MDL in a plan view. For example, a portion of the cathode electrode CE, which is exposed by the bank BNK (or does not overlap the bank BNK), may be covered by the intermediate insulating layer MDL.

In some embodiments, the cathode electrode CE may overlap the light emitting element LD in a plan view. For example, a portion of the cathode electrode CE, which is exposed by the bank BNK (or does not overlap the bank BNK), may be covered by the light emitting element LD.

The bank BNK may cover the anode electrode AE and the cathode electrode CE, and expose at least a portion of each of the anode electrode AE and the cathode electrode CE. The bank BNK may form (or include) an opening OP. The bank BNK may protrude in the thickness direction of the substrate SUB (e.g., the third direction DR3), and surround an area.

The bank BNK may include various materials. For example, the bank BNK may include an organic material. The bank BNK may include at least one selected from the group consisting of acrylic resin, epoxy resin, phenolic resin, polyamide resin, and polyimide resin. However, embodiments are not limited thereto.

The bank BNK may define an area in which the light emitting element LD is disposed. For example, the bank BNK may surround the area in which the light emitting element LD is disposed. In some embodiments, the area surrounded by the bank BNK may correspond to an emission area EMA defined by the light emitting element LD.

The bank BNK may define an area in which the intermediate insulating layer MDL is disposed. For example, the bank BNK may surround the area in which the intermediate insulating layer MDL is disposed.

The intermediate insulating layer MDL may be disposed in the area surrounded by the bank BNK. The intermediate insulating layer MDL may be disposed in the opening OP. For convenience of descriptions, in FIG. 7 and a plan view related thereto, the position of the intermediate insulating layer MDL is indicated by a dotted line box.

The intermediate insulating layer MDL may overlap the cathode electrode CE in a plan view. The intermediate insulating layer MDL may not overlap the bridge cathode electrode CE_BR in a plan view. The intermediate insulating layer MDL may not overlap the anode electrode AE in a plan view.

The intermediate insulating layer MDL may overlap the light emitting element LD in a plan view. The intermediate insulating layer MDL may cover (e.g., entirely cover) the light emitting element LD in a plan view. The intermediate insulating layer MDL may be adjacent (e.g., directly adjacent) to the light emitting element LD. For example, the intermediate insulating layer MDL may fill a space in which the light emitting element LD is not disposed within the opening OP.

The intermediate insulating layer MDL may include first to third intermediate insulating layers separated from each other to correspond to (or overlap) the respective sub-pixels SP. Accordingly, the intermediate insulating layers MDL may be provided in openings OP corresponding to the first to third sub-pixels SP1 to SP3, respectively.

The intermediate insulating layer MDL may include various materials. For example, the intermediate insulating layer MDL may include an organic material. In some embodiments, the intermediate insulating layer MDL may include at least one selected from the group consisting of acrylic resin, epoxy resin, phenolic resin, polyamide resin, and polyimide resin. However, embodiments are not limited thereto.

The reflective electrode layer RE_A and RE_C may be disposed adjacent to the bottom surface (or lower surface) of the light emitting element LD. In some embodiments, the reflective electrode layer RE_A and RE_C may overlap the light emitting element LD in a plan view.

The reflective electrode layer RE_A and RE_C may include an anode reflective electrode layer RE_A and a cathode reflective electrode layer RE_C. The anode reflective electrode layer RE_A and the cathode reflective electrode layer RE_C may be electrically separated from each other in the display area DA. The anode reflective electrode layer RE_A and the cathode reflective electrode layer RE_C may be formed by a same process, and be physically spaced apart from each other. The anode reflective electrode layer RE_A and the cathode reflective electrode layer RE_C may be disposed in (or formed as) a same layer, and include a same reflective material.

The reflective electrode layer RE_A and RE_C may include a reflective material, and form a reflective wall (or reflective surface). For example, the reflective material may include at least one selected from the group consisting of gold (Au), silver (Ag), aluminium (Al), molybdenum (Mo), chromium (Cr), titanium (Ti), nickel (Ni), neodymium (Nd), copper (Cu), and platinum (Pt). However, embodiments are not limited thereto. As the reflective electrode layer RE_A and RE_C includes the reflective material, a light recycling structure may be formed, and the light emission efficiency of the light emitting element LD may be improved.

The anode reflective electrode layer RE_A may include a first anode reflective electrode layer RE_A1, a second anode reflective electrode layer RE_A2, and a third anode reflective electrode layer RE_A3. The first anode reflective electrode layer RE_A1, the second anode reflective electrode layer RE_A2, and the third anode reflective electrode layer RE_A3 may be spaced apart from each other. The first anode reflective electrode layer RE_A1 may be included in the first sub-pixel SP1. The second anode reflective electrode layer RE_A2 may be included in the second sub-pixel SP2. The third anode reflective electrode layer RE_A3 may be included in the third sub-pixel SP3.

Each of the first anode reflective electrode layer RE_A1, the second anode reflective electrode layer RE_A2, and the third anode reflective electrode layer RE_A3 may have an isolated island shape. The first anode reflective electrode layer RE_A1, the second anode reflective electrode layer RE_A2, and the third anode reflective electrode layer RE_A3 may be sequentially disposed along the first direction DR1.

The anode reflective electrode layer RE_A may overlap an anode transparent electrode layer TCE_A in a plan view. The anode reflective electrode layer RE_A may not overlap a cathode transparent electrode layer TCE_C in a plan view.

The anode reflective electrode layer RE_A may be spaced apart from the light emitting element LD. For example, the anode reflective electrode layer RE_A may not overlap the light emitting element LD in a plan view.

The cathode reflective electrode layer RE_C may include a first cathode reflective electrode layer RE_C1, a second cathode reflective electrode layer RE_C2, and a third cathode reflective electrode layer RE_C3. The first cathode reflective electrode layer RE_C1, the second cathode reflective electrode layer RE_C2, and the third cathode reflective electrode layer RE_C3 may be spaced apart from each other. The first cathode reflective electrode layer RE_C1 may be included in the first sub-pixel SP1. The second cathode reflective electrode layer RE_C2 may be included in the second sub-pixel SP2. The third cathode reflective electrode layer RE_C3 may be included in the third sub-pixel SP3.

Each of the first cathode reflective electrode layer RE_C1, the second cathode reflective electrode layer RE_C2, and the third cathode reflective electrode layer RE_C3 may have an isolated island shape. The first cathode reflective electrode layer RE_C1, the second cathode reflective electrode layer RE_C2, and the third cathode reflective electrode layer RE_C3 may be sequentially disposed along the first direction DR1.

In some embodiments, the cathode reflective electrode layer RE_C may cover a wide area. For example, the cathode reflective electrode layer RE_C may have a wide and flat shape. The cathode reflective electrode layer RE_C may include a wide overlapping area as compared with the base cathode electrode CE_B.

The cathode reflective electrode layer RE_C may overlap the anode transparent electrode layer TCE_A and the cathode transparent electrode layer TCE_C in a plan view. The cathode reflective electrode layer RE_C may overlap the light emitting element LD in a plan view. In some embodiments, the cathode reflective electrode layer RE_C may cover (e.g., entirely cover) the light emitting element LD in a plan view.

In some embodiments, the cathode reflective electrode layer RE_C may form a reflective surface on the bottom surface (or lower surface) of the light emitting element LD. The reflective surface may include a main surface facing the light emission direction of the display device DD. Accordingly, the cathode reflective electrode layer RE_C may form a light recycling structure.

The cathode reflective electrode layer RE_C may be connected (e.g., electrically connected) to the cathode electrode CE. The cathode reflective electrode layer RE_C may form a potential corresponding to the second power voltage, and supply a cathode signal. Since the cathode reflective electrode layer RE_C may also have a flat shape, the cathode reflective electrode layer RE_C may have a small resistance, and accordingly, a risk that a voltage in the display area DA drops may be reduced.

The transparent electrode layers TCE_A and TCE_C may be disposed adjacent to the top surface (or upper surface) of the light emitting element LD. In some embodiments, the transparent electrode layers TCE_A and TCE_C may overlap the light emitting element LD in a plan view. The transparent electrode layers TCE_A and TCE_C may be adjacent (e.g., directly adjacent) to the intermediate insulating layer MDL.

The transparent electrode layers TCE_A and TCE_C may include the anode transparent electrode layer TCE_A and the cathode transparent electrode layer TCE_C. The anode transparent electrode layer TCE_A and the cathode transparent electrode layer TCE_C may be electrically separated from each other in the display area DA. The anode transparent electrode layer TCE_A and the cathode transparent electrode layer TCE_C may be formed by a same process, and be physically spaced apart from each other. The anode transparent electrode layer TCE_A and the cathode transparent electrode layer TCE_C may be disposed in a same layer, and include a same transparent conductive material. For example, the transparent conductive material may include at least one selected from the group consisting of silver nano wire (AgNW), Indium Tin Oxide (ITO), Indium Zinc Oxide (IZO), Indium Gallium Zinc Oxide (IGZO), Antimony Zinc Oxide (AZO), Indium Tin Zinc Oxide (ITZO), Zinc Oxide (ZnO), Tin Oxide (SnO2), carbon nano tube, and graphene. However, embodiments are not limited thereto.

The anode transparent electrode layer TCE_A may include a first anode transparent electrode layer TCE_A1, a second anode transparent electrode layer TCE_A2, and a third anode transparent electrode layer TCE_A3. The first anode transparent electrode layer TCE_A1, the second anode transparent electrode layer TCE_A2, and the third anode transparent electrode layer TCE_A3 may be spaced apart from each other. The first anode transparent electrode layer TCE_A1 may be included in the first sub-pixel SP1. The second anode transparent electrode layer TCE_A2 may be included in the second sub-pixel SP2. The third anode transparent electrode layer TCE_A3 may be included in the third sub-pixel SP3.

Each of the first anode transparent electrode layer TCE_A1, the second anode transparent electrode layer TCE_A2, and the third anode transparent electrode layer TCE_A3 may have an isolated island shape. The first anode transparent electrode layer TCE_A1, the second anode transparent electrode layer TCE_A2, and the third anode transparent electrode layer TCE_A3 may be sequentially disposed along the first direction DR1.

The anode transparent electrode layer TCE_A may overlap the light emitting element LD in a plan view. The anode transparent electrode layer TCE_A may be connected (e.g., electrically connected) to the anode reflective electrode layer RE_A, and be connected (e.g., electrically connected) to the light emitting element LD.

The cathode transparent electrode layer TCE_C may overlap the light emitting element LD in a plan view. The cathode transparent electrode layer TCE_C may be connected (e.g., electrically connected) to the cathode reflective electrode layer RE_C, and be connected (e.g., electrically connected) to the light emitting element LD.

The cathode transparent electrode layer TCE_C may include a first cathode transparent electrode layer TCE_C1 and a second cathode transparent electrode layer TCE_C2. The first cathode transparent electrode layer TCE_C1 may extend along the first direction DR1, and be disposed (or extend) throughout the first to third sub-pixels SP1 to SP3 in the first direction DR1. The second cathode transparent electrode layer TCE_C2 may extend along the second direction DR2, and be disposed (or extend) throughout different pixels PXL adjacent to each other along the second direction DR2. The second cathode transparent electrode layer TCE_C2 may be disposed between anode transparent electrodes TCE_A adjacent to each other.

Light emitting elements LD may include an inorganic light emitting diode. However, embodiments are not limited thereto.

The light emitting elements LD may include a first light emitting element LD1 included in the first sub-pixel SP1, a second light emitting element LD2 included in the second sub-pixel SP2, and a third light emitting element LD3 included in the third sub-pixel SP3.

For convenience of description, FIG. 9 illustrates a cross-sectional structure of the display device DD with respect to the first sub-pixel SP1. However, features of the display device DD in accordance with the embodiment, described with reference to FIG. 9, may be equally applied to the other sub-pixels SP.

Referring to FIGS. 9 and 10, the pixel circuit layer PCL, a display element layer DPL, and a light functional layer LFL may be sequentially disposed on the substrate SUB.

The pixel circuit layer PCL may include insulating layers, semiconductor patterns, and conductive patterns, which are stacked on the substrate SUB. The insulating layers may include a buffer layer BFL, one or more interlayer insulating layers ILD, and one or more passivation layers PSV1 and PSV2. The semiconductor patterns and the conductive patterns may be positioned between the insulating layers. The conductive patterns may include at least one material among copper (Cu), molybdenum (Mo), tungsten (W), aluminium neodymium (AlNd), titanium (Ti), aluminium (Al), and silver (Ag).

As described with reference to FIG. 2, the sub-pixel circuit SPC (see FIG. 2) of each of the first to third sub-pixels SP1 to SP3 may include transistors and one or more capacitors. The semiconductor patterns and the conductive patterns of the pixel circuit layer PCL may function as the transistors and the capacitors of the sub-pixel circuit SPC. For example, the conductive patterns of the pixel circuit layer PCL may further function as lines, e.g., the first to m-th gate lines GL1 to GLm, the first to n-th data lines DL1 to DLn, the power lines PL, and the pixel control lines PXCL, which are shown in FIG. 1.

The buffer layer BFL may be disposed on a surface of the substrate SUB. The buffer layer BFL may prevent an impurity from being diffused (or permeated) into circuit elements and lines, which are included in the pixel circuit layer PCL. The buffer layer BFL may include an inorganic insulating layer including an inorganic material. In embodiments, the buffer layer BFL may include at least one of silicon nitride (SiNx), silicon oxide (SiOx), silicon oxynitride (SiOxNy), and a metal oxide such as aluminium oxide (AlOx). The buffer layer BFL may be provided (or formed) as a single layer or a multi-layer. In a case that the buffer layer BFL is provided (or formed) as the multi-layer, layers of the multi-layer may be formed of a same material or be formed of different materials.

In embodiments, one or more barrier layers may be disposed between the substrate SUB and the buffer layer BFL. Each of the barrier layers may include polyimide.

A transistor T_SP may be disposed on the buffer layer BFL. The transistor T_SP may be any one of the transistors of the sub-pixel circuit SPC included in the sub-pixel SP.

The transistor T_SP may include a semiconductor pattern SCP, a gate electrode GE, a first terminal ET1, and a second terminal ET2. The first terminal ET1 may be any one of a source electrode and a drain electrode, and the second terminal ET2 may be the other of the source electrode and the drain electrode. For example, the first terminal ET1 may be the source electrode, and the second terminal ET2 may be the drain electrode.

The semiconductor pattern SCP may be disposed on the buffer layer BFL. The semiconductor pattern SCP may include a first contact region in contact with the first terminal ET1 and a second contact region in contact with the second terminal ET2. A region between the first contact region and the second contact region may be a channel region. The channel region may overlap the gate electrode GE of the transistor T_SP. The channel region is a semiconductor pattern undoped with an impurity, and may be an intrinsic semiconductor. Each of the first contact region and the second contact region may be a semiconductor pattern doped with the impurity. For example, a p-type impurity may be used as the impurity, but embodiments are not limited thereto.

The semiconductor pattern SCP may include any one of various types of semiconductors, e.g., any one of an amorphous silicon semiconductor, a monocrystalline silicon semiconductor, a polycrystalline silicon semiconductor, a low temperature poly-silicon (LTPS) semiconductor, and an oxide semiconductor.

The sequentially stacked interlayer insulating layers ILD may be disposed over the semiconductor pattern SCP. The interlayer insulating layers ILD may be inorganic insulating layers including an inorganic material. For example, each of the interlayer insulating layers ILD may include at least one of silicon nitride (SiNx), silicon oxide (SiOx), silicon oxynitride (SiOxNy), and a metal oxide such as aluminium oxide (AlOx). However, the interlayer insulating layers ILD are not limited thereto. For example, any one of the interlayer insulating layers ILD may include an organic insulating layer including an organic material.

The interlayer insulating layers ILD may electrically separate the conductive patterns and/or the semiconductor patterns, which are disposed between the interlayer insulating layers ILD. For example, the interlayer insulating layers ILD may include a gate insulating layer GI disposed on the semiconductor pattern SCP. The gate insulating layer GI may be disposed between the semiconductor pattern SCP and the gate electrode GE such that the gate electrode GE may be spaced apart from the semiconductor pattern SCP. In embodiments, the gate insulating layer GI may be provided (e.g., entirely provided) on the semiconductor pattern SCP and the buffer layer BFL, to cover the semiconductor pattern SCP and the buffer layer BFL. As the number of layers required in the conductive patterns and/or the semiconductor patterns increases, the number of interlayer insulating layers ILD may increase.

The gate electrode GE may be disposed on the gate insulating layer GI. The gate electrode GE may overlap the channel region of the semiconductor pattern SCP. The gate electrode GE may be provided (or formed) as a single layer including at least one material among copper (Cu), molybdenum (Mo), tungsten (W), aluminium neodymium (AlNd), titanium (Ti), aluminium (Al), and silver (Ag). In embodiments, the gate electrode GE may be provided (or formed) as a multi-layer including at least one material among molybdenum (Mo), titanium (Ti), copper (Cu), aluminium (Al), and silver (Ag), which are low resistance materials.

The first and second terminals ET1 and ET2 may be disposed on the interlayer insulating layers ILD. The first and second terminals ET1 and ET2 may be in contact with the semiconductor pattern SCP through contact holes penetrating the interlayer insulating layers ILD. The first and second terminals ET1 and ET2 may be in contact with the first and second contact regions of the semiconductor pattern SCP, respectively. Each of the first and second terminals ET1 and ET2 may include at least one material among copper (Cu), molybdenum (Mo), tungsten (W), aluminium neodymium (AlNd), titanium (Ti), aluminium (Al), and silver (Ag).

Although the first and second terminals ET1 and ET2 are illustrated as separate electrodes connected (e.g., electrically connected) to the semiconductor pattern SCP, embodiments are not limited thereto. In some embodiments, the first terminal ET1 may be the first contact region adjacent to a side of the channel region of the semiconductor pattern SCP, and the second terminal ET2 may be the second contact region adjacent to the other side of the channel region of the semiconductor pattern SCP. The first terminal ET1 may be connected (e.g., electrically connected) to the light emitting element LD through a connection means such as a bridge electrode disposed on at least one of the interlayer insulating layers ILD.

In embodiments, the transistor T_SP may be formed as a low temperature poly-silicon transistor. However, embodiments are not limited thereto. For example, the transistor T_SP may be formed as an oxide semiconductor transistor. In embodiments, the sub-pixel circuit SPC of the first sub-pixel SP1 may include different types of transistors. For example, the transistor T_SP may be formed as a low temperature poly-silicon transistor, and another transistor of the first sub-pixel SP1 may be formed as an oxide semiconductor transistor. An oxide semiconductor of the corresponding oxide semiconductor transistor may be disposed on any one of the interlayer insulating layers ILD instead of an insulating layer on which the semiconductor pattern SCP of the transistor T_SP.

In embodiments, a case where the transistor T_SP is a transistor having a top gate structure is described as an example. However, embodiments are not limited thereto. For example, the transistor T_SP may be a transistor having a bottom gate structure. For example, the structure of the transistor T_SP may be variously changed.

At least a portion of various lines of the display panel DP and/or the display device DD may be further disposed on the interlayer insulating layers ILD.

A first passivation layer PSV1 may be disposed over transistors T_SP. The passivation layer may function as a protective layer or a via layer. The first passivation layer PSV1 may protect components disposed thereunder, and provide a flat top surface (or flat upper surface).

A connection pattern CP may be disposed on the first passivation layer PSV1. The connection pattern CP may be connected to the first terminal ET1 of the transistor T_SP through penetrating the first passivation layer PSV1. The connection pattern CP may include at least one material among copper (Cu), molybdenum (Mo), tungsten (W), aluminium neodymium (AlNd), titanium (Ti), aluminium (Al), and silver (Ag).

At least a portion of various lines of the display panel DP and/or the display device DD may be further disposed on the first passivation layer PSV1.

A second passivation layer PSV2 may be disposed on the connection pattern CP and the first passivation layer PSV1. The second passivation layer PSV2 may protect components disposed thereunder, and provide a flat top surface (or flat upper surface).

Each of the first and second passivation layers PSV1 and PSV2 may include an inorganic insulating layer including an inorganic material and/or an organic insulating layer including an organic material. The inorganic insulating layer may include, for example, at least one of silicon oxide (SiOx), silicon nitride (SiNx), silicon oxynitride (SiOxNy), and a metal oxide such as aluminium oxide (AlOx). The organic insulating layer may include, for example, at least one of acrylic resin, epoxy resin, phenolic resin, polyamide resin, polyimide resin, unsaturated polyester resin, poly-phenylene ether resin, poly-phenylene sulfide resin, and benzocyclobutene resin.

The first and second passivation layers PSV1 and PSV2 and the interlayer insulating layers ILD may include a same material, but embodiments are not limited thereto. Each of the first and second passivation layers PSV1 and PSV2 may be provided (or formed) as a single layer, but be provided (or formed) as a multi-layer.

The display element layer DPL may be disposed on the second passivation layer PSV2. The display element layer DPL may include an anode electrode AE, a cathode electrode CE, a bank BNK, a reflective electrode layer RE_A and RE_C, a light emitting element LD, an intermediate insulating layer MDL, transparent electrode layers TCE_A and TCE_C, and a capping layer CPL.

The anode electrode AE and the cathode electrode CE may be spaced apart from each other to respectively form an anode signal path and a cathode signal path. The anode electrode AE may be connected (e.g., electrically connected) to the transistor T_SP through a contact portion CNT penetrating a portion of the second passivation layer PSV2.

The cathode electrode CE may have an extended shape as compared with the anode electrode AE, and cover a wide area. As described above, the cathode electrode CE may cover (e.g., entirely cover) the bottom surface (or lower surface) of the light emitting element LD, thereby forming a light recycling structure.

The bank BNK may cover a portion of each of the anode electrode AE and the cathode electrode CE, and form an opening OP. In some embodiments, the bank BNK may function as a pixel defining layer defining the sub-pixel SP.

A cathode reflective electrode layer RE_C may be connected (e.g., electrically connected) to the cathode electrode CE. For example, the cathode reflective electrode layer RE_C and the cathode electrode CE may be in contact with each other, and form a cathode contact surface ECS_C. The cathode contact surface ECS_C may form a plane extending in the first direction DR1 and the second direction DR2. The cathode contact surface ECS_C may be defined as an extended area. The cathode contact surface ECS_C may cover (e.g., entirely cover) the bottom surface (or lower surface) of the light emitting element LD. The cathode contact surface ECS_C may overlap the light emitting element LD in a plan view.

An anode reflective electrode layer RE_A may be connected (e.g., electrically connected) to the anode electrode AE. The anode reflective electrode layer RE_A and the anode electrode AE may be in contact with each other, and form an anode contact surface ECS_A. The anode contact surface ECS_A may not overlap the light emitting element LD in a plan view.

The anode reflective electrode layer RE_A may be disposed on a surface of the bank BNK, and the surface of the bank BNK, on which the anode reflective electrode layer RE_A is disposed, may not face the light emitting element LD. For example, the cathode reflective electrode layer RE_C may be disposed on a surface of the bank BNK, and the surface of the bank BNK, on which the cathode reflective electrode layer RE_C is disposed, may face the light emitting element LD. Accordingly, a risk that a short circuit between the anode reflective electrode layer RE_A and the cathode reflective electrode layer RE_C occurs may be reduced.

The light emitting element LD may be disposed on a surface of the cathode reflective electrode layer RE_C overlapping the cathode contact surface ECS_C. In some embodiments, the light emitting element LD may be bonded to the cathode reflective electrode layer RE_C.

The light emitting element LD may include a first semiconductor layer 31, an active layer 32, a second semiconductor layer 33, and an auxiliary layer 35. The first light emitting element LD1 may include a light emitting stack structure in which the auxiliary layer 35, the first semiconductor layer 31, the active layer 32, and the second semiconductor layer 33 are sequentially stacked.

The light emitting element LD may include first and second elements electrodes BDE1 and BDE2 facing in a same direction (e.g., the third direction DR3). The first element electrode BDE1 may be connected to the second semiconductor layer 33. The second element electrode BDE2 may be connected to the first semiconductor layer 31 exposed as the second semiconductor layer 33 and the active layer 32 are exposed. The light emitting element LD may be a lateral chip type light emitting element.

The first semiconductor layer 31 may provide electrons to the active layer 32. The first semiconductor layer 31 may include, for example, at least one n-type semiconductor layer. For example, the first semiconductor layer 31 may include any one semiconductor material among gallium nitride (GaN), aluminium gallium nitride (AlGaN), indium gallium nitride (InGaN), aluminium nitride (AlN), and indium nitride (InN), and be an n-type semiconductor layer doped with a first conductive dopant (or n-type dopant) such as silicon (Si), germanium (Ge) or tin (Sn). However, the material of the first semiconductor layer 31 is not limited thereto. For example, various materials may constitute (or form) the first semiconductor layer 31. In an embodiment, the first semiconductor layer 31 may include a gallium nitride (GaN) semiconductor material doped with the first conductive dopant (or n-type dopant). In some embodiments, the first semiconductor layer 31 along with the auxiliary layer 35 may constitute (or form) an n-type semiconductor layer.

The active layer 32 may be disposed on the first semiconductor layer 31, and may be an area in which electrons and holes are recombined. As electrons and holes are recombined in the active layer 32, light may be generated, which has a level changed to a low energy level and has a wavelength corresponding to the low energy level. The active layer 32 may be formed in a single quantum well structure or a multi-quantum well structure. In a case that the active layer 32 is formed in the multi-quantum well structure, a unit including a barrier layer, a strain reinforcing layer, and a well layer may be repeatedly stacked, to form the active layer 32. However, embodiments are not limited thereto.

The second semiconductor layer 33 may be disposed on the active layer 32, and provides holes to the active layer 32. The second semiconductor layer 33 may include a semiconductor layer of which type is different from the type of the first semiconductor layer 31. In an example, the second semiconductor layer 33 may include at least one p-type semiconductor layer. For example, the second semiconductor layer 33 may include any one semiconductor material among gallium nitride (GaN), aluminium gallium nitride (AlGaN), indium gallium nitride (InGaN), aluminium nitride (AlN), and indium nitride (InN), and be a p-type semiconductor layer doped with a second conductive dopant (or p-type dopant) such as magnesium (Mg), zinc (Zn), calcium (Ca), strontium (Sr) or barium (Ba). However, the material of the second semiconductor layer 33 is not limited thereto. For example, various materials may constitute (or form) the second semiconductor layer 33. In an embodiment, the second semiconductor layer 33 may include a gallium nitride (GaN) semiconductor material doped with the second conductive dopant (or p-type dopant).

The auxiliary layer 35 may include a gallium nitride (GaN) semiconductor material undoped with an impurity. The auxiliary layer 35 along with the first semiconductor layer 31 may constitute (or form) an n-type semiconductor layer.

The first element electrode BDE1 may be connected (e.g., electrically connected) to the second semiconductor layer 33. The second element electrode BDE2 may be connected (e.g., electrically connected) to the first semiconductor layer 31.

The light emitting element LD may further include an insulative film 36 covering an outer circumferential surface of the light emitting stack structure. The insulative film 36 may prevent an electrical short circuit which may occur in a case that the active layer 32 is in contact with another conductive material except the first and second semiconductor layers 31 and 33. The insulative film 36 may include a transparent insulating material. The insulative film 36 may expose top surfaces (or upper surfaces) of the first and second element electrodes BDE1 and BDE2.

The intermediate insulating layer MDL may be adjacent to the light emitting element LD, the cathode reflective electrode layer RE_C, and the bank BNK, and fill the space in the opening OP.

The intermediate insulating layer MDL may reduce a step difference formed by the light emitting element LD. The maximum height of the intermediate insulating layer MDL may correspond to (or be substantially equal to) a height of a side portion of the light emitting element LD. For example, a height of a corner portion of the light emitting element LD and the maximum height of the intermediate insulating layer MDL may be substantially same as each other. For example, a difference between the height of the corner portion of the light emitting element LD and the maximum height of the intermediate insulating layer MDL may be smaller than a thickness of the transparent electrode layers TCE_A and TCE_C (e.g., a minimum thickness of the transparent electrode layers TCE_A and TCE_C in the display area DA). Accordingly, a risk that the transparent electrode layers TCE_A and TCE_C forming a cathode path or an anode path is disconnected from each other may be reduced.

A cathode transparent electrode layer TCE_C may be connected (e.g., electrically connected) to the cathode reflective electrode layer RE_C, and be connected (e.g., electrically connected) to the second element electrode BDE2. An anode transparent electrode layer TCE_A may be connected (e.g., electrically connected) to the anode reflective electrode layer RE_A, and be connected (e.g., electrically connected) to the first element electrode BDE1.

The cathode transparent electrode layer TCE_C may overlap the second element electrode BDE2 in a plan view. The anode transparent electrode layer TCE_A may overlap the first element electrode BDE1 in a plan view. The anode transparent electrode layer TCE_A may overlap the cathode reflective electrode layer RE_C and the anode reflective electrode RE_A in a plan view. In a plan view, the cathode transparent electrode layer TCE_C may overlap the cathode reflective electrode layer RE_C, and may not overlap the anode reflective electrode layer RE_A.

In some embodiments, the cathode transparent electrode layer TCE_C and the cathode reflective electrode layer RE_C may be electrically connected (or directly connected) to each other. For example, the cathode transparent electrode layer TCE_C and the cathode reflective electrode layer RE_C may form an electrical contact surface with no insulating layer interposed therebetween, to be connected (e.g., electrically connected) to each other. The anode transparent electrode layer TCE_A and the anode reflective electrode layer RE_A may be electrically connected (or directly connected) to each other. For example, the anode transparent electrode layer TCE_A and the anode reflective electrode layer RE_A may form an electrical contact surface with no insulating layer interposed therebetweeen, to be connected (e.g., electrically connected) to each other.

In accordance with an embodiment, an electrical contact area between the cathode transparent electrode layer TCE_C and the cathode reflective electrode layer RE_C and an electrical contact area between the anode transparent electrode layer TCE_A and the anode reflective electrode layer RE_A may be extended. Accordingly, an electrical connection path may be thoroughly defined, and a risk that a dark spot is generated in the display area DA, which occurs in a case that any electrical connection path is not defined, may be reduced.

In accordance with an embodiment, any insulating layer may not be interposed between the cathode transparent electrode layer TCE_C and the cathode reflective electrode layer RE_C and between the anode transparent electrode layer TCE_A and the anode reflective electrode layer RE_A, and accordingly, the number of masks used in the manufacturing process for the display element layer DPL may be decreased.

In accordance with an embodiment, an allowable deviation of the position at which the light emitting element LD is disposed may be increased, and accordingly, process convenience may be improved. For example, the light emitting element LD may be transferred on the pixel circuit layer PCL, using various transfer methods. For example, the light emitting element LD may be transferred according to at least one method among a transfer method using a stamp, a transfer method using laser, a transfer method using an electrostatic force, a transfer method using a magnetic force and an electromagnetic force, and a transfer method using an adhesive. However, embodiments are not limited thereto.

Experimentally, in a case that both electrodes are connected (e.g., electrically connected) to each other through a contact hole formed in an insulating layer after the corresponding insulating layer is interposed between the cathode transparent electrode layer TCE_C and the cathode reflective electrode layer RE_C and between the anode transparent electrode layer TCE_A and the anode reflective electrode layer RE_A, it is necessary that a position of the contact hole and a transfer position of the light emitting element LD should be defined to correspond to each other, and accordingly, the allowable deviation of the position at which the light emitting element LD is disposed may be decreased. Therefore, a risk that the process convenience is deteriorated may occur. However, in accordance with the embodiment, an electrical path may be defined without any contact hole, so that the electrical contact area between the cathode transparent electrode layer TCE_C and the cathode reflective electrode layer RE_C and the electrical contact area between the anode transparent electrode layer TCE_A and the anode reflective electrode layer RE_A may be extended. Accordingly, the above-described risk may be reduced.

The capping layer CPL may be disposed over other components of the display element layer DPL. For example, the capping layer CPL may be disposed over the bank BNK, the reflective electrodes RE_A and RE_C, the transparent electrodes TCE_A and TCE_C, and the light emitting element LD, and protect the components from external moisture, humidity, and the like. The capping layer CPL may include at least one of silicon nitride (SiNx), silicon oxide (SiOx), silicon oxynitride (SiOxNy), and a metal oxide such as aluminium oxide (AlOx). However, the material of the capping layer CPL is not limited thereto.

The light functional layer LFL may be disposed on the capping layer CPL. The light functional layer LFL may include an upper bank QBNK, a reflective layer RFE, an intermediate passivation layer QPSV, a first light conversion pattern CCP1, a low refractive layer LRL, and a color filter layer CFL.

The upper bank QBNK may be disposed on the capping layer CPL. The upper bank QBNK may overlap the bank BNK in a plan view. The upper bank QBNK may surround an area.

The upper bank QBNK may include various materials. For example, the upper bank QBNK may include an organic material. In some embodiments, the upper bank QBNK may include at least one selected from the group consisting of acrylic resin, epoxy resin, phenolic resin, polyamide resin, and polyimide resin. However, embodiments are not limited thereto.

The reflective layer RFE may be disposed on a side surface of the upper bank QBNK. The reflective layer RFL may reflect incident light, and accordingly, light emission efficiency may be improved. The reflective layer RFL may include a material suitable for reflecting light. The reflective layer RFL may include at least one of aluminium (Al), silver (Ag), magnesium (Mg), platinum (Pt), palladium (Pd), gold (Au), nickel (Ni), neodymium (Nd), iridium (Ir), chromium (Cr), titanium (Ti), and alloys of two or more materials selected therefrom. However, embodiments are not limited thereto.

The intermediate passivation layer QPSV may be disposed on the capping layer CPL. The intermediate passivation layer QPSV may protect components disposed thereunder, and provide a flat top surface (or flat upper surface). The intermediate passivation layer QPSV and the first and second passivation layers PSV1 and PSV2 may include a same material, but embodiments are not limited thereto.

The first light conversion pattern CCP1 may include color conversion particles and/or light scattering particles. The color conversion particles may convert incident light into light of another color by changing a wavelength of the incident light. For example, the color conversion particles may scatter incident light. In embodiments, the color conversion particles may be quantum dots. The light scattering particles may scatter incident light.

The first sub-pixel SP1 may be a red sub-pixel. In a case that the first light emitting element LD1 emits light of a blue color, the first light conversion pattern CCP1 may include first color conversion particles QD1 that convert light of the blue color into light of a red color. In a case that the first light emitting element LD1 emits light of the red color, the first light conversion pattern CCP1 may include light scattering particles. For example, the particles included in the first light conversion pattern CCP1 may be variously changed according to the first light emitting element LD1.

The low refractive layer LRL may be disposed on the upper bank QBNK, the reflective layer RFE, and the first light conversion pattern CCP1. The low refractive layer LRL may have a refractive index lower than a refractive index of the first light conversion pattern CCP1. The low refractive layer LRL may refract (or totally reflect) light according to an incident angle of the corresponding light. For example, the low refractive layer LRL may again provide light passing through the first light conversion pattern CCP1 to the first light conversion pattern CCP1. Accordingly, the light conversion efficiency of the first light conversion pattern CCP1 may be improved.

The color filter layer CFL may be disposed on the low refractive layer LRL. The color filter layer CFL may include a first color filter CF1 and light blocking patterns LBP. The first color filter CF1 may overlap the first light conversion pattern CCP1. The first color filter CF1 may selectively transmit light in a desired wavelength range therethrough. In a case that the first sub-pixel SP1 is a red sub-pixel, the first color filter CF1 may include a red color filter. The light blocking patterns LBP may include at least one of various kinds of light blocking materials. In some embodiments, the light blocking patterns LBP may be formed as first to third color filters CF1 to CF3 overlapping each other.

Referring to FIG. 11, the pixel circuit layer PCL, the display element layer DPL, and the light functional layer LFL may be provided (or disposed) on the substrate SUB.

The pixel circuit layer PCL and the display element layer DPL are a same as described with reference to the previous drawings. In the pixel circuit layer PCL, sub-pixel circuits SPC may be provided (or formed), which respectively correspond to (or overlap) the first to third sub-pixels SP1 to SP3. In the display element layer DPL, first to third light emitting elements LD1 to LD3 may be provided (or formed), which respectively correspond to (or overlap) the first to third sub-pixels SP1 to SP3. Each of the first to third light emitting elements LD1 to LD3 may be disposed in an area surrounded by the bank BNK. The first light emitting element LD1 may be connected between the cathode electrode CE and the transistor T_SP included in the sub-pixel circuit SPC of the first sub-pixel SP1. The second light emitting element LD2 may be connected between the cathode electrode CE and a transistor included in the sub-pixel circuit SPC of the second sub-pixel SP2. The third light emitting element LD3 may be connected between the cathode electrode CE and a transistor included in the sub-pixel circuit SPC of the third sub-pixel SP3. Hereinafter, redundant descriptions will be omitted for descriptive convenience.

The light functional layer LFL may be provided (or disposed) on the display element layer DPL. The light functional layer LFL is a same as described with reference to FIG. 10. Hereinafter, redundant descriptions will be omitted for descriptive convenience.

The upper bank QBNK may have upper openings COP. Emission areas EMA and a non-emission area NEMA of the first to third sub-pixels SP1 to SP3 may be defined by the upper bank QBNK. An area with which the upper bank QBNK overlaps may correspond to the non-emission area NEMA. Areas overlapping the upper openings COP of the upper bank QBNK may correspond to the emission areas EMA of the first to third sub-pixels SP1 to SP3.

On the capping layer CPL, the intermediate passivation layer QPSV may be disposed in the upper openings COP. On the intermediate passivation layer QPSV, first and second light conversion patterns CCP1 and CCP2 and a light scattering pattern LSP may be disposed in the upper openings COP.

In embodiments, the first to third light emitting elements LD1 to LD3 may emit light of a blue color. The first light conversion pattern CCP1 may include first color conversion particles QD1 that convert light of the blue color into light of a red color. The second light conversion pattern CCP2 may include second color conversion particles QD2 that convert light of the blue color into light of a green color. The light scattering pattern LSP may include light scattering particles SCT which scatter light of the blue color so as to improve light emission efficiency. Accordingly, the first to third sub-pixels SP1 to SP3 may be provided (or formed) as a red sub-pixel, a green sub-pixel, and a blue sub-pixel, respectively. In embodiments, at least one of the first and second light conversion patterns CCP1 and CCP2 and the light scattering pattern LSP may further include color conversion particles that convert light of the blue color into light of a white color.

In embodiments, the first to third light emitting elements LD1 to LD3 may emit lights of the red color, the green color, and the blue color, respectively. Each of the first and second light conversion patterns CCP1 and CCP2 and the light scattering pattern LSP may include light scattering particles SCT. For example, the particles included in the first and second light conversion patterns CCP1 and CCP2 and the light scattering pattern LSP may be variously changed according to the first to third light emitting elements LD1 to LD3.

In embodiments, the first and second light conversion patterns CCP1 and CCP2 and the light scattering pattern LSP may be omitted.

The low refractive layer LRL may be disposed on the upper bank QBNK, the reflective layer RFE, the first and second light conversion patterns CCP1 and CCP2, and the light scattering pattern LSP. The low refractive layer LRL may have a refractive index lower than a refractive index of each of the first and second light conversion patterns CCP1 and CCP2, and the light scattering pattern LSP. In embodiments, the low refractive layer LRL may be omitted in an area corresponding to the third sub-pixel SP3.

The color filter layer CFL may be disposed on the low refractive layer LRL. The color filter layer CFL may include first to third color filters CF1 to CF3 and light blocking patterns LBP.

Each of the first to third color filters CF1 to CF3 may selectively transmit light in a desired wavelength range therethrough. In a case that the first sub-pixel SP1 is a red sub-pixel, the first color filter CF1 may include a red color filter. In a case that the second sub-pixel SP2 is a green sub-pixel, the second color filter CF2 may include a green color filter. In a case that the third sub-pixel SP3 is a blue sub-pixel, the third color filter CF3 may include a blue color filter.

The light blocking patterns LBP may be disposed between the color filters CF1 to CF3. It may be understood that the emission areas (or light emission areas) EMA and the non-emission area NEMA of the first to third sub-pixels SP1 to SP3 are defined by the light blocking patterns LBP. Areas corresponding to the light blocking patterns LBP may correspond to the non-emission area NEMA. Areas not overlapping the light blocking patterns LBP may correspond to the emission areas EMA.

In embodiments, the light blocking patterns LBP may include at least one of various kinds of light blocking materials. In embodiments, each of the light blocking patterns LBP may be provided (or formed) in the form of a multi-layer in which at least two color filters among the first to third color filters CF1 to CF3 overlap each other. For example, each of the light blocking patterns LBP may be formed as the first to third color filters CF1 to CF3 overlap each other. In another example, a light blocking pattern between the first and second color filters CF1 and CF2 among the light blocking patterns LBP may be formed as a multi-layer in which the first and second color filters CF1 and CF2 overlap each other, and a light blocking pattern between the second and third color filters CF2 and CF3 among the light blocking patterns LBP may be formed as a multi-layer in which the second and third color filters CF2 and CF3 overlap each other. A light blocking pattern between the first color filter CF1 and a third color filter CF3 of an adjacent pixel may be formed as a multi-layer in which the first and third color filters CF1 and CF3 overlap each other. For example, each of the first to third color filters CF1 to CF3 may extend to the non-emission area NEMA to form the light blocking patterns LBP.

A display device DD in accordance with another embodiment will be described with reference to FIG. 12. In FIG. 12, portions overlapping those described above will be briefly described or will not be repeated for descriptive convenience.

Referring to FIG. 12, the display device DD in accordance with the another embodiment different from the display device DD in accordance with the embodiment, which is described above with reference to FIGS. 6 to 11, in that an anode electrode AE has an extended structure like the cathode electrode CE of the above-described embodiment and a cathode electrode CE has a narrow structure like the anode electrode AE of the above-described embodiment.

In this embodiment, the anode electrode AE, an anode reflective electrode layer RE_A, and an anode transparent electrode layer TCE_C may have structural features similar (or substantially identical) to structural features of the cathode electrode CE, the cathode reflective electrode layer RE_C, and the cathode transparent electrode layer TCE_C in the embodiment described above with reference to FIGS. 6 to 11. In this embodiment, the cathode electrode CE, a cathode reflective electrode layer RE_C, and a cathode transparent electrode layer TCE_C may have structural features similar (or substantially identical) to structural features of the anode electrode AE, the anode reflective electrode layer RE_A, and the anode transparent electrode layer TCE_A in the embodiment described above with reference to FIGS. 6 to 11.

For example, the anode electrode AE may cover a wide area as compared with the cathode electrode CE, and form a reflective surface on the bottom surface (or lower surface) of a light emitting element LD. The cathode electrode CE may cover a narrow area as compared with the anode electrode AE, and may not overlap the light emitting element LD in a plan view. For example, the anode electrode AE may overlap (e.g., entirely overlap) the light emitting element LD in a plan view. An anode contact surface ECS_A may cover (e.g., entirely cover) the light emitting element LD in a plan view. A cathode contact surface ECS_C may not overlap the light emitting element LD in a plan view. Besides, in accordance with an embodiment, like the embodiments described above with reference to FIGS. 6 to 11, the anode reflective electrode layer RE_A and the anode transparent electrode layer TCE_A may be electrically connected (or directly connected) to each other, and the cathode reflective electrode layer RE_C and the cathode transparent electrode layer TCE_C may be electrically connected (or directly connected) each other. Accordingly, process convenience may be improved, a risk that a dark spot is generated may be reduced, and the number of masks used in processes may be decreased.

An identification pattern EGP included in the display device DD in accordance with an embodiment will be described with reference to FIGS. 13 and 14. In FIGS. 13 and 14, portions overlapping those described above will be briefly described or will not be repeated for descriptive convenience.

Referring to FIGS. 13 and 14, the display device DD in accordance with the embodiment may further include an identification pattern EGP.

The identification pattern EGP may be a structure formed at a portion of a conductive layer formed in the display element layer DPL. The identification pattern EGP may provide information for determining an alignment position of a light emitting element LD in a case that a process of transferring the light emitting element LD on the pixel circuit layer PCL is performed. For example, a position of the identification pattern EGP may be formed to be adjacent to a position at which the light emitting element LD is to be disposed, and whether the light emitting element LD has been normally transferred may be determined based on the position of the identification pattern EGP.

In some embodiments, the identification pattern EGP may surround an area in which the light emitting element LD is disposed in a plan view. For example, a portion of the identification pattern EGP may be disposed at a first side (e.g., an upper side) of the light emitting element LD, a portion of the identification pattern EGP may be disposed at a second side (e.g., a lower side) of the light emitting element LD, a portion of the identification pattern EGP may be disposed at a third side (e.g., a left side) of the light emitting element LD, and a portion of the identification pattern EGP may be disposed at a fourth side (e.g., a right side) of the light emitting element LD.

In some embodiments, the identification pattern EGP may be provided to be patterned in at least one of the conductive layers included in the display element layer DPL. In some embodiments, the identification pattern EGP may include an engraved pattern and/or an embossed pattern, formed in at least one of the conductive layers included in the display element layer DPL.

For example (see FIG. 13), the identification pattern EGP may be formed at a portion of the cathode electrode CE (e.g., the base cathode electrode CE_B). In another example (see FIG. 14), the identification pattern EGP may be formed at a portion of the cathode reflective electrode layer RE_C. However, embodiments are not limited thereto.

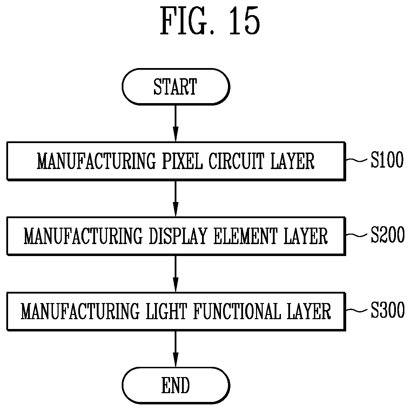

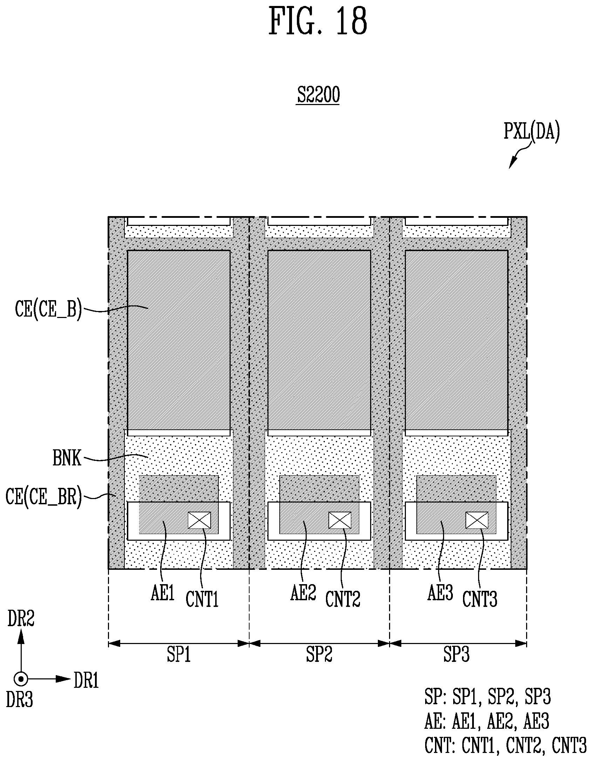

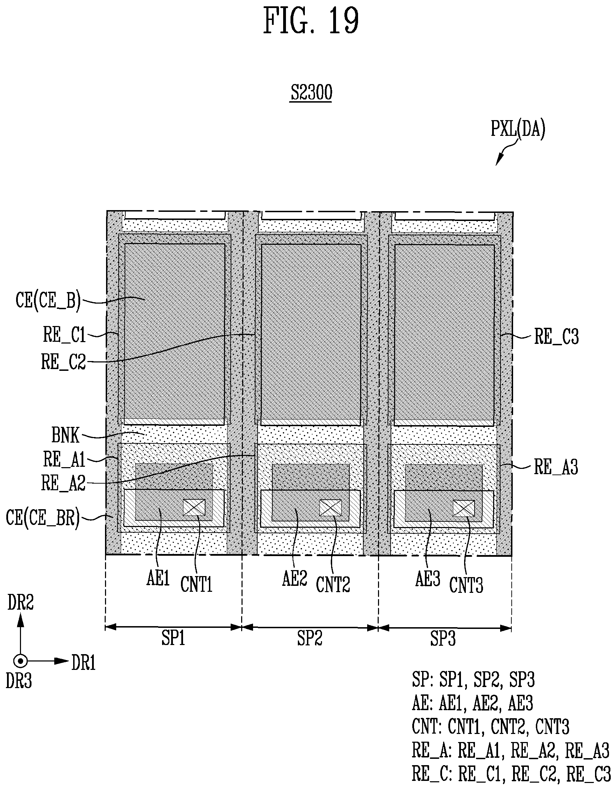

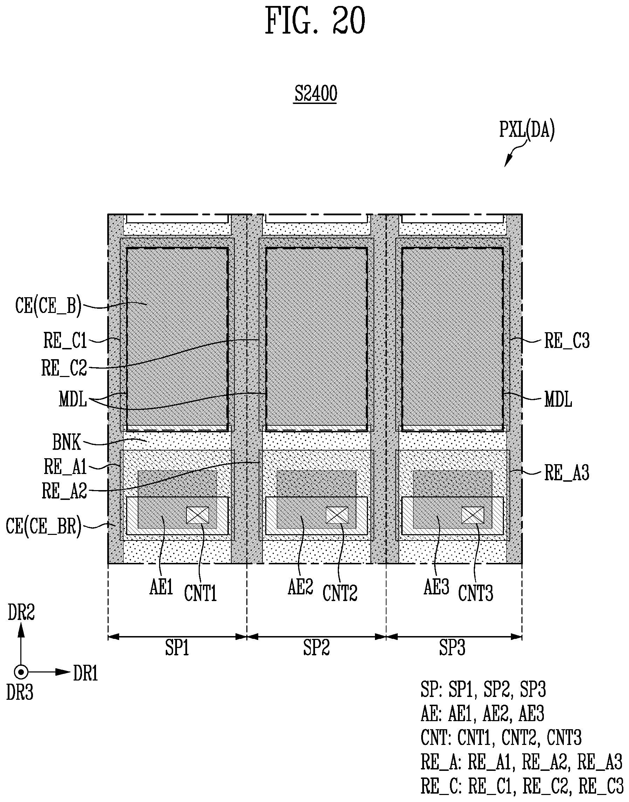

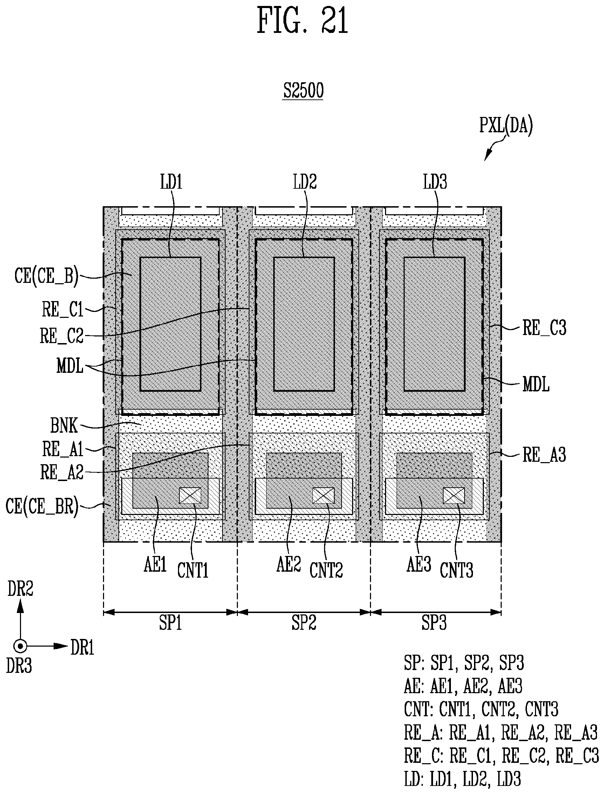

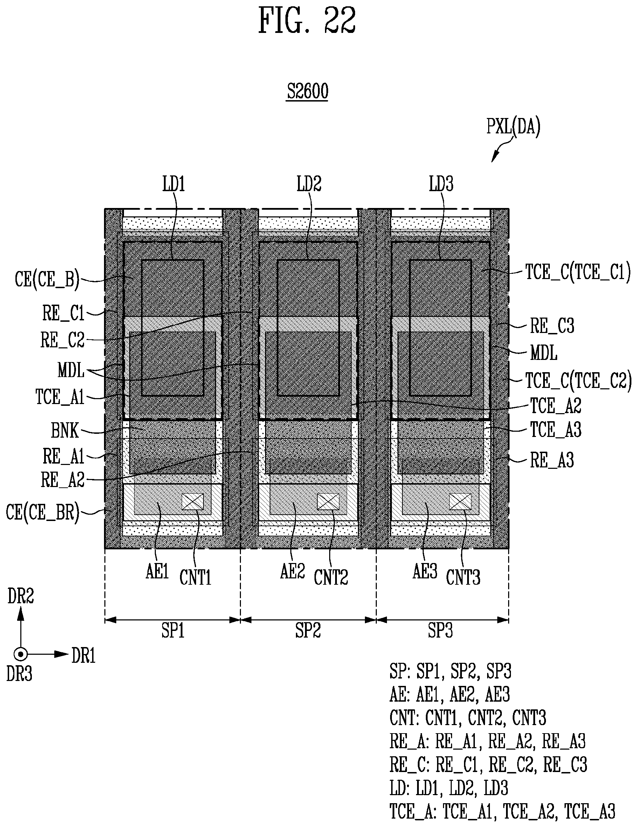

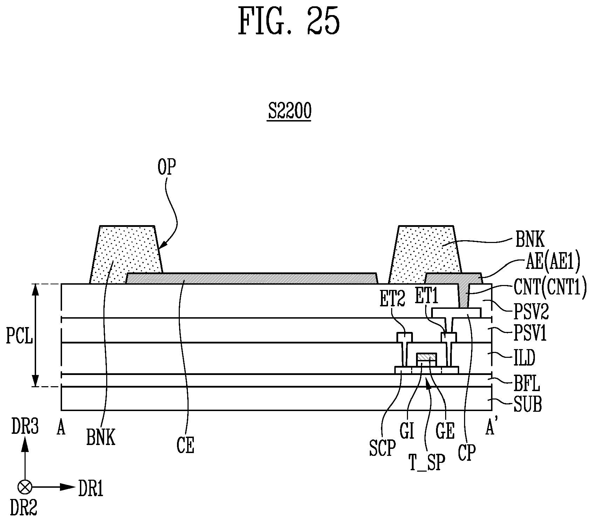

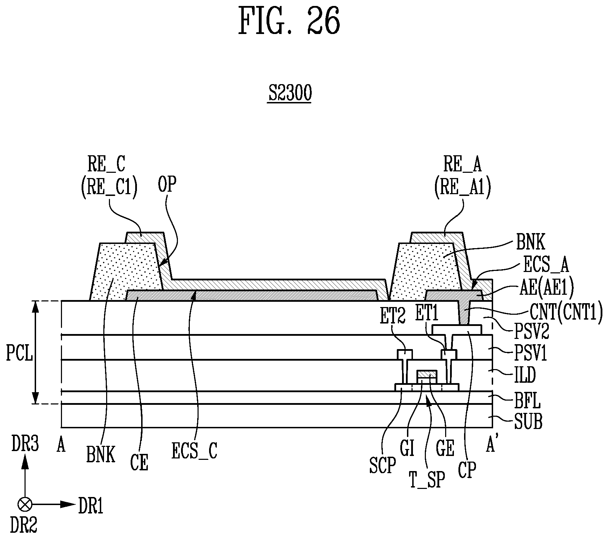

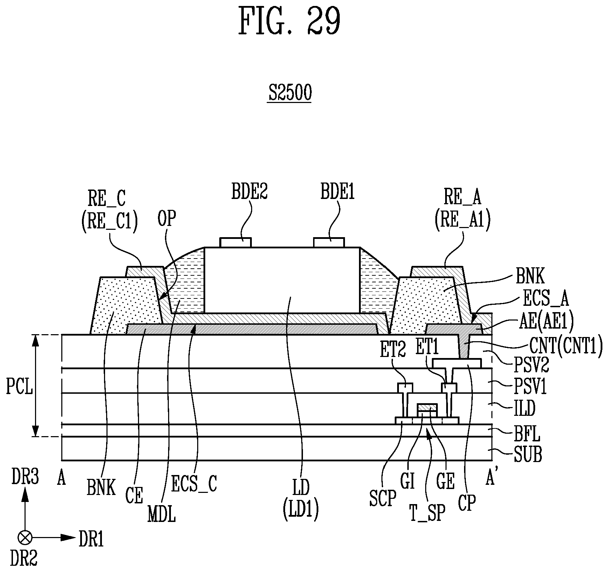

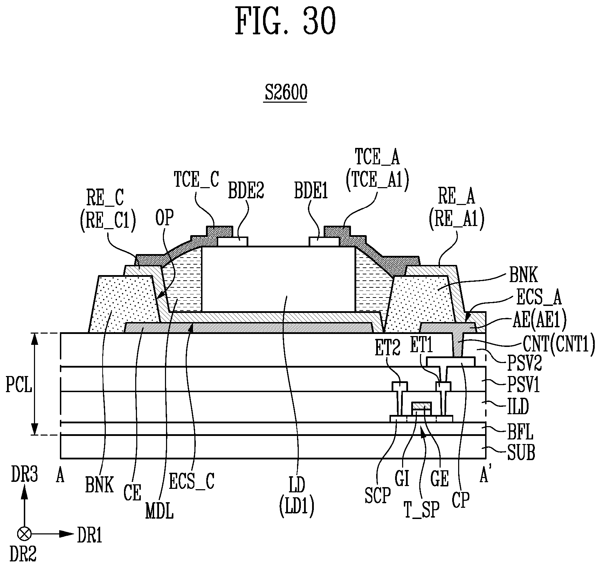

Hereinafter, a method of manufacturing a display device DD in accordance with an embodiment will be described with reference to FIGS. 15 to 31. In FIGS. 15 to 31, portions overlapping those described above will be briefly described or will not be repeated for descriptive convenience.

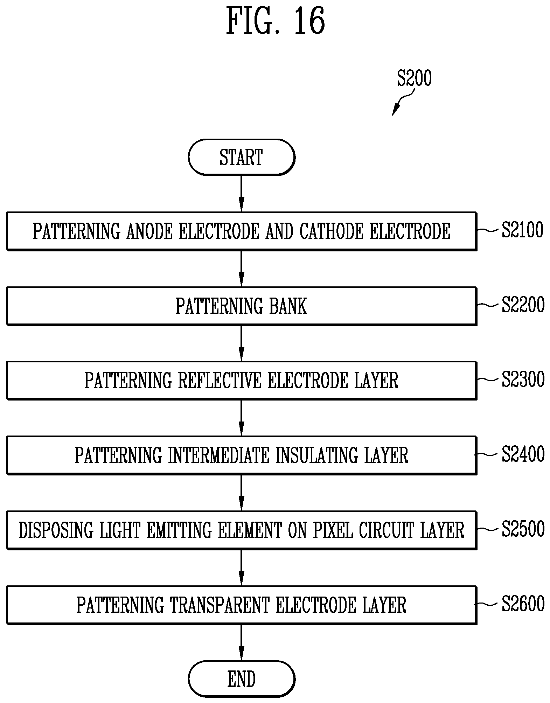

FIG. 15 is a schematic flowchart illustrating a method of manufacturing a display device in accordance with an embodiment. FIG. 16 is a schematic flowchart illustrating a step of manufacturing a display element layer in accordance with an embodiment.

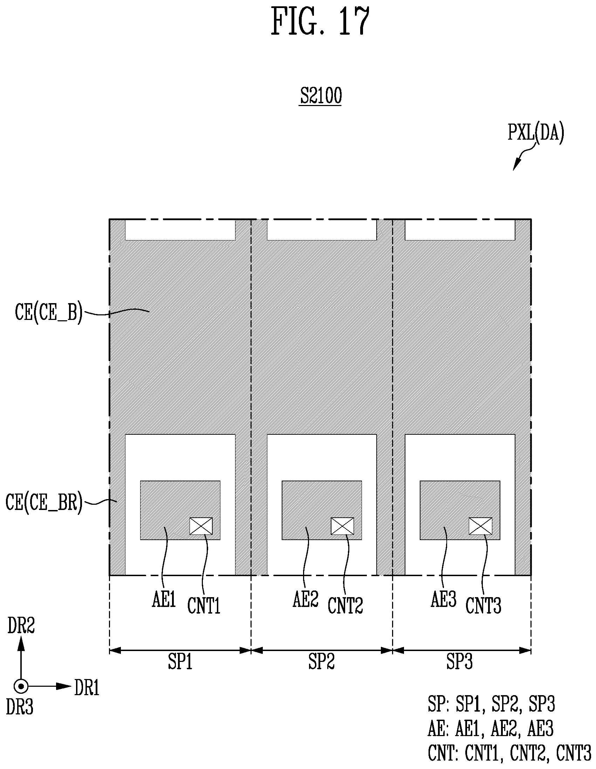

FIGS. 17 to 22 are schematic plan views illustrating process steps of the method of manufacturing the display device in accordance with an embodiment. For convenience of description, FIGS. 17 to 22 schematically illustrate an area corresponding to the planar structure described above with reference to FIGS. 6 and 7.

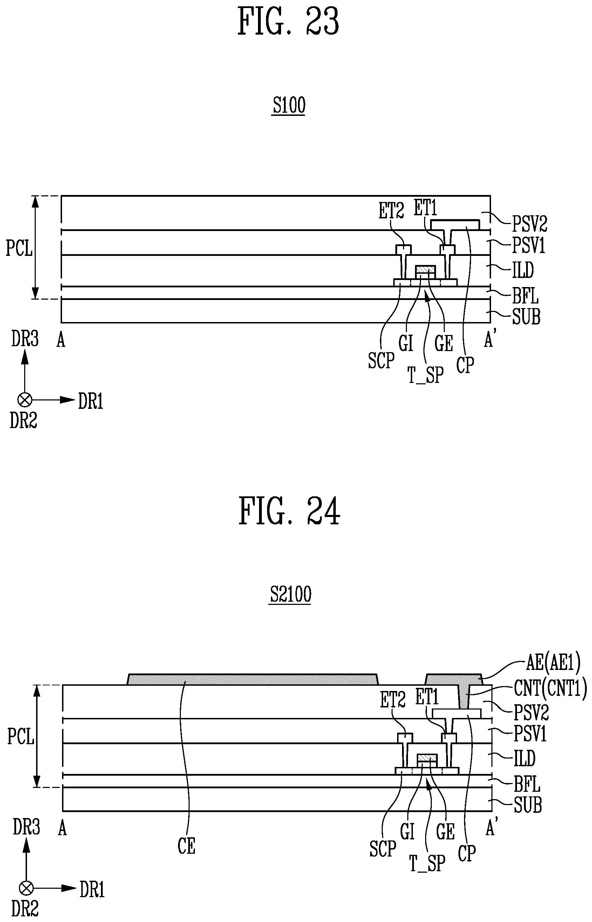

FIGS. 23 to 31 are schematic cross-sectional views illustrating process steps of the method of manufacturing the display device in accordance with an embodiment. For convenience of description, FIGS. 23 to 31 schematically illustrate an area corresponding to the cross-sectional structure described above with reference to FIG. 9.

Referring to FIG. 15, the method of manufacturing the display device DD in accordance with the embodiment may include step S100 of manufacturing a pixel circuit layer, step S200 of manufacturing a display element layer, and step S300 of manufacturing a light functional layer.

Referring to FIG. 16, the step S200 of manufacturing the display element layer may include step S2100 of patterning an anode electrode and a cathode electrode, step S2200 of patterning a bank, step S2300 of patterning a reflective electrode layer, step S2400 of patterning an intermediate insulating layer, step S2500 of disposing a light emitting element on the pixel circuit layer, and step S2600 of patterning a transparent electrode layer.

Referring to FIGS. 15 and 23, in the step S100 of manufacturing the pixel circuit layer, a pixel circuit layer PCL may be disposed on a substrate SUB.

In some embodiments, a conductive layer or an insulating layer on the substrate SUB may be formed by an ordinary process for manufacturing a semiconductor device. For example, the conductive layer or the insulating layer on the substrate SUB may be formed by a photolithography process, be etched by various processes (e.g., wet etching, dry etching, and the like), and be deposited by various processes (e.g., sputtering, chemical vapor deposition, and the like). However, embodiments are not limited to a specific example.

In this step S100, a transistor T_SP may be patterned on the substrate SUB, and a buffer layer BFL, an interlayer insulating layer ILD, a first passivation layer PSV1, and a second passivation layer PSV2 may be formed.

Referring to FIGS. 15 to 17 and 24, in the step S2100 of patterning the anode electrode and the cathode electrode, an anode electrode AE and a cathode electrode CE may be formed on the pixel circuit layer PCL (or the substrate SUB).

In this step S2100, the cathode electrode CE covering a wide area may be patterned. For example, a base cathode electrode CE_B covering first to third sub-pixels SP1 to SP3 may be formed, and a bridge cathode electrode CE_BR extending in a direction may be formed.

In some embodiments, an area in which the base cathode electrode CE_B is patterned may correspond to an area in which light emitting elements LD and a cathode reflective electrode layer RE_C are disposed in subsequent processes.

In this step S2100, the anode electrode AE covering a narrow area may be patterned. For example, first to third anode electrodes AE1 to AE3 may be formed, which are isolated from each other to be spaced apart from each other.

In this step S2100, in a case that the anode electrode AE is formed, a contact portion CNT connected (e.g., electrically connected) to the transistor T_SP may be formed.

Referring to FIGS. 15, 16, 18, and 25, in the step S2200 of patterning the bank, a bank BNK may be formed on the pixel circuit layer PCL (or the substrate SUB).

In this step S2200, the bank BNK surrounding each of two or more areas may be patterned to form an opening OP. For example, the bank BNK may expose a portion of the base cathode electrode CE_B, and may expose a portion of the anode electrode AE.

In some embodiments, the portion of the base cathode electrode CE_B, which the bank BNK exposes, may form a cathode contact surface ECS_C. The portion of the anode electrode AE, which the bank BNK exposes, may form an anode contact surface ECS_A.

Referring to FIGS. 15, 16, 19, and 26, in the step S2300 of patterning the reflective electrode layer, reflective electrode layers RE_A and RE_C may be formed on the pixel circuit layer PCL (or the substrate SUB).

In this step S2300, a cathode reflective electrode layer RE_C covering a wide area may be patterned. For example, first to third cathode reflective electrode layers RE_C1 to RE_C3 may be formed, which respectively cover areas of the first to third sub-pixels SP1 to SP3.

In this step S2300, an anode reflective electrode layer RE_A covering a narrow area may be patterned. For example, first to third anode reflective electrode layers RE_A1 to RE_A3 may be formed, which respectively cover areas of the first to third sub-pixels SP1 to SP3.

In some embodiments, the anode reflective electrode layer RE_A may overlap an area in which the light emitting element LD is disposed in a subsequent process. Accordingly, the anode reflective electrode layer RE_A may form a reflective surface for forming a light recycling structure.

In this step S2300, the anode reflective electrode layer RE_A and the anode electrode AE may be in contact with each other, be connected (e.g., electrically connected) to each other, and form the anode contact surface ESC_A. The cathode reflective electrode layer RE_C and the cathode electrode CE may be in contact with each other, be connected (e.g., electrically connected) to each other, and form the cathode contact surface ESC_C.

In this step S2300, the anode reflective electrode layer RE_A may expose a portion of the bank BNK. The cathode reflective electrode layer RE_C may expose a portion of the bank BNK. In some embodiments, a side surface of the bank BNK, which the cathode reflective electrode layer RE_C exposes, may face an area in which the cathode contact surface ECS_C is disposed.

Referring to FIGS. 15, 16, 20, 27, and 28, in the step S2400 of patterning the intermediate insulating layer, an intermediate insulating layer MDL may be disposed in the opening OP formed by the bank BNK.

In this step S2400, the intermediate insulating layer MDL may be provided in the area surrounded by the bank BNK. For example, the intermediate insulating layer MDL may overlap the base cathode electrode CE_B and the cathode reflective electrode layer RE_C. In some embodiments, the intermediate insulating layer MDL may not overlap the anode electrode AE and the anode reflective electrode layer RE_A.

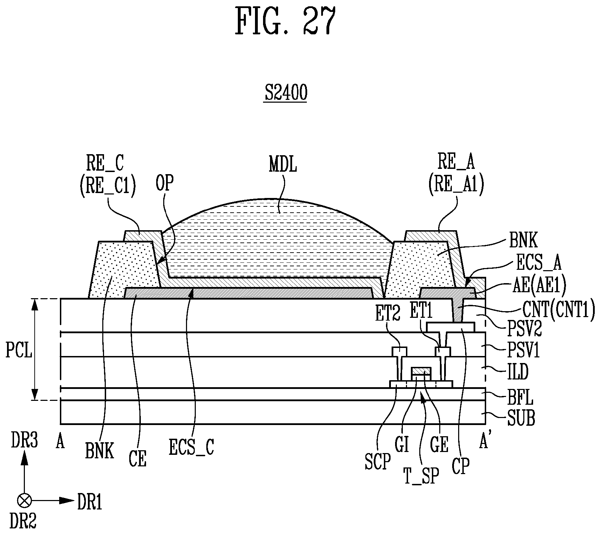

In accordance with an embodiment (FIG. 27), the intermediate insulating layer MDL may be formed on the pixel circuit layer PCL (or the substrate SUB), by a process such as deposition.

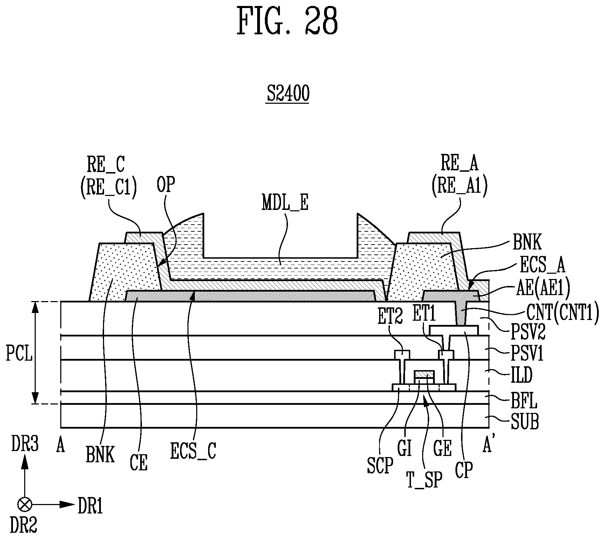

In accordance with an embodiment (FIG. 28), after the intermediate insulating layer MDL is formed, an additional etching process may be further performed, and a pre-etched intermediate insulating layer MDL_E may be manufactured. For example, the pre-etched intermediate insulating layer MDL_E may be provided by performing an additional etching process, using a halftone mask, after the intermediate insulating layer MDL is formed. In some embodiments, the pre-etched intermediate insulating layer MDL_E may further include a groove portion, and the groove portion may be an area in which the light emitting element LD is disposed in a subsequent process. Accordingly, the alignment degree of the light emitting element LD may be further improved.

Referring to FIGS. 15, 16, 21, and 29, in the step S2500 of disposing the light emitting element on the pixel circuit layer, the light emitting element LD may be disposed in the opening OP.

In this step S2500, the light emitting element LD may be disposed on the substrate SUB (or the pixel circuit layer PCL), using various transfer methods. However, embodiments are not limited to a specific example.

In this step S2500, the light emitting element LD may be disposed on the intermediate insulating layer MDL (or the pre-etched intermediate insulating layer MDL). The light emitting element LD may be disposed on the base cathode electrode CE_B (or the cathode reflective electrode layer RE_C).

In this step S2500, the light emitting element LD may be aligned such that first and second element electrodes BDE1 and BDE2 of the light emitting element LD may face upwards (e.g., the third direction DR3). Accordingly, the first and second element electrodes BDE1 and BDE2 of the light emitting element LD may be exposed.

In this step S2500, the first and second element electrodes BDE1 and BDE2 of the light emitting element LD may not be connected (e.g., electrically connected) to the anode reflective electrode layer RE_A and the cathode reflective electrode layer RE_C.

Referring to FIGS. 15, 16, 22, and 30, in the step S2600 of patterning the transparent electrode layer, an anode transparent electrode layer TCE_A and a cathode transparent electrode layer TCE_C may be disposed.

In this step S2600, the cathode transparent electrode layer TCE_C overlapping the second element electrode BDE2 may be patterned. For example, a first cathode transparent electrode layer TCE_C1 extending in the first direction DR1 to be disposed throughout the first to third sub-pixels SP1 to SP3 may be patterned, and a second cathode transparent electrode layer TCE_C2 extending in the second direction may be patterned.

In this step S2600, the anode transparent electrode layer TCE_A overlapping the first element electrode BDE1 may be patterned. For example, first to third anode transparent electrode layers TCE_A1 to TCE_A3 respectively covering areas of the first to third sub-pixels SP1 to SP3 may be formed.

In this step S2600, the second element electrode BDE2 and the cathode transparent electrode layer TCE_C may be in contact with (e.g., in direct contact with) each other. The first element electrode BDE1 and the anode transparent electrode layer TCE_A may be in contact with (e.g., in direct contact with) each other. As described above, an electrical connection structure may be formed by a direct contact between electrodes.

After that, a capping layer CPL covering each layer of the display element layer DPL may be formed.

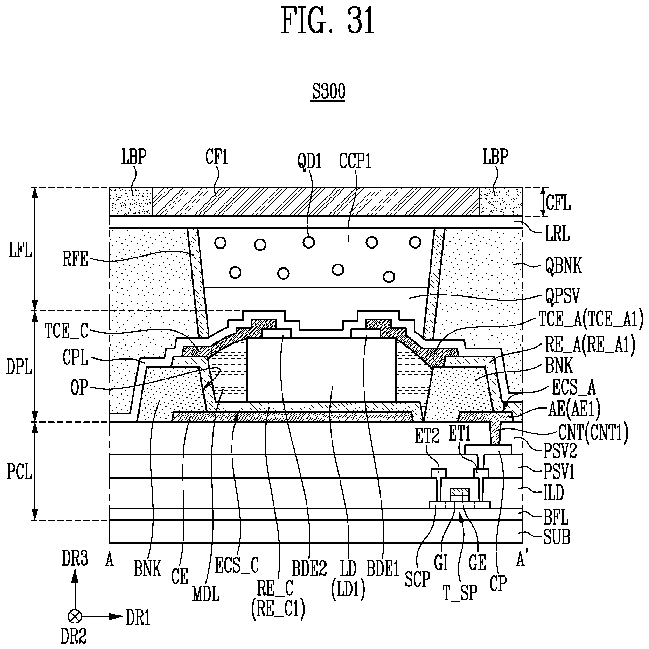

Referring to FIGS. 15 and 31, in the step S300 of manufacturing the light functional layer, a light functional layer LFL may be disposed on the display element layer DPL.

In this step S300, layers for forming the light functional layer LFL may be sequentially formed on the display element layer DPL. For example, an upper bank QBNK, a reflective layer RFE, an intermediate passivation layer QPSV, first and second light conversion patterns CCP1 and CCP2, a light scattering pattern LSP, a low refractive layer LRL, and a color filter layer CFL may be formed on the capping layer CPL.

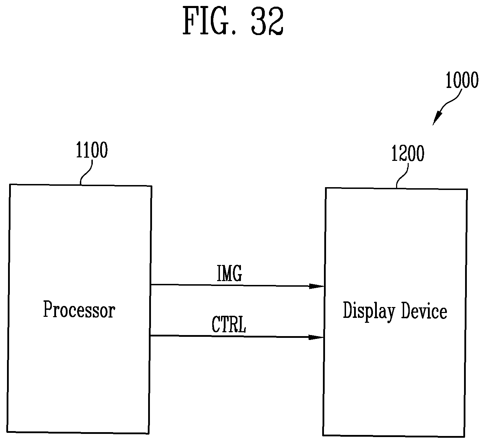

FIG. 32 is a schematic block diagram illustrating an embodiment of a display system.

Referring to FIG. 32, a display system 1000 may include a processor 1100 and a display device 1200.

The processor 1100 may perform various tasks and various calculations. In embodiments, the processor 1100 may include an Application Processor, a Graphics Processing Unit, a microprocessor, a Central Processing Unit (CPU), and the like. The processor 1100 may be connected to other components of the display system 1000 through a bus system to control the components of the display system 1000.

The processor 1100 may transmit input image data IMG and a control signal CTRL to the display device 1200. The display device 1200 may display an image, based on the input image data IMG and the control signal CTRL. The display device 1200 may be substantially identical (or similar) to the display device DD described with reference to FIG. 1. The input image data IMG and the control signal CTRL may be provided (or formed) as the input image data IMG and the control signal CTRL, which are shown in FIG. 1, respectively.

The display system 1000 may include a computing system for providing an image display function, such as a smart watch, a mobile phone, a smartphone, a portable computer, a tablet personal computer (PC), a watch phone, an automotive display, a smart glass, a portable multimedia player (PMP), a navigation system, or an ultra-mobile computer (UMPC). The display system 1000 may include at least one of a head mounted display (HMD) device, a virtual reality (VR) device, a mixed reality (MR) device, and an augmented reality (AR) device.

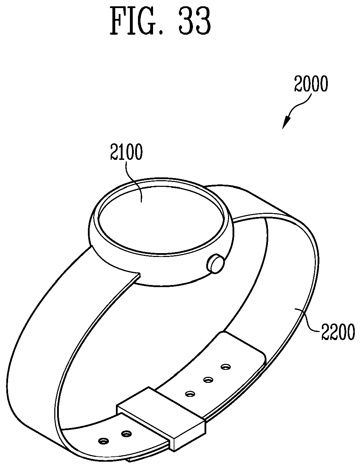

FIGS. 33 to 36 are schematic perspective views illustrating application examples of the display system shown in FIG. 32.

Referring to FIG. 33, the display system 1000 shown in FIG. 32 may be applied to a smart watch 2000 including a display part 2100 and a strap part 2200.

The smart watch 2000 may be a wearable electronic device. For example, the smart watch 2000 may have a structure in which the strap part 2200 is mounted on a wrist of a user. The display system 1000 and/or the display device 1200 may be applied to the display part 2100, so that input image data including time information may be provided to the user.

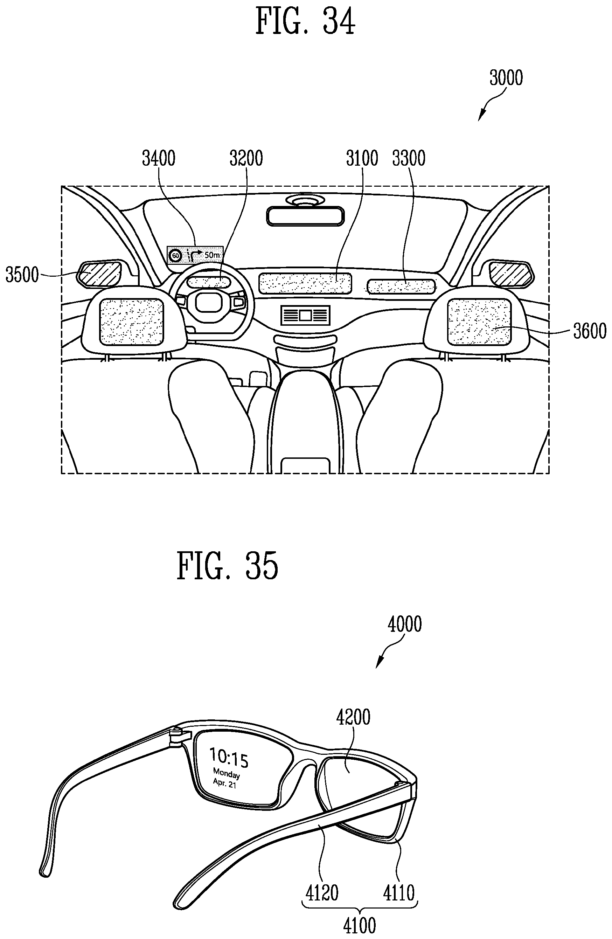

Referring to FIG. 34, the display system 1000 shown in FIG. 32 may be applied to an automotive display system 3000. The automotive display system 3000 may include a computing system provided at the inside/outside of a vehicle to provide input image data.

For example, the display system 1000 and/or the display device 1200 may be applied to at least one of an infotainment panel 3100, a cluster 3200, a co-driver display device 3300, a head-up display device 3400, a side mirror display device 3500, and a read seat display device 3600, which are provided in the vehicle.

Referring to FIG. 35, the display system 1000 shown in FIG. 32 may be applied to smart glasses 4000. The smart glasses 4000 may be a wearable electronic device which is worn on the face of a user. For example, the smart glasses 4000 may be a wearable device for Augmented Reality .

The smart glasses 4000 may include a frame 4100 and a lens part 4200. The frame 4100 may include a housing 4110 supporting the lens part 4200 and a leg part 4120 for enabling the user to wear the smart glasses 4000. The leg part 4120 may be connected to the housing 4110 through a hinge, to be folded or unfolded with respect to the housing 4110.

A battery, a touch pad, a microphone, a camera, and the like may be built in the frame 4100. For example, a projector for outputting light, a processor for controlling a light signal, and the like may be built in the frame 4100.

The lens part 4200 may be an optical member which transmits light therethrough or reflects light thereby. For example, the lens part 4200 may include glass, transparent synthetic resin, and the like.

In order to enable eyes of the user to recognize visual information, the lens part 4200 may enable an image caused by a light signal transmitted from the projector of the frame 4100 to be reflected by a rear surface (e.g., a surface in a direction facing the eyes of the user) of the lens part 4200. For example, the user may recognize information including time, data, and the like, which are displayed on the lens part 4200. The projector and/or the lens part 4200 may be a kind of display device. The display device 1200 may be applied to the projector and/or the lens part 4200.

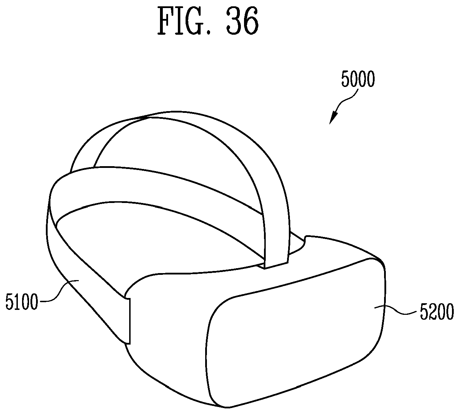

Referring to FIG. 36, the display system 1000 shown in FIG. 32 may be applied to a head mounted display device 500.

The head mounted display device 5000 may be a wearable electronic device which is worn on the head of a user. For example, the head mounted display device 5000 may be a wearable device for virtual reality or mixed reality.

The head mounted display device 5000 may include a head mounted band 5100 and a display accommodating case 5200. The head mounted band 5100 may be connected to the display accommodating case 5200. The head mounted band 5100 may include a horizontal band and/or a vertical band, used to fix the head mounted display device 5000 to the head of the user. The horizontal band may surround a side portion of the head of the user, and the vertical band may surround an upper portion of the head of the user. However, embodiments are not limited thereto. For example, the head mounted band 5100 may be implemented in the form of a glasses frame, a helmet, or the like.

The display accommodating case 5200 may accommodate the display system 1000 and/or the display device 1200.

In concluding the detailed description, those skilled in the art will appreciate that many variations and modifications may be made to the embodiments without substantially departing from the principles and spirit and scope of the disclosure. Therefore, the disclosed embodiments are used in a generic and descriptive sense only and not for purposes of limitation.

## Claims

1. A display device comprising:
a substrate; and
a display element layer disposed on the substrate,
wherein the display element layer includes:
an anode electrode and a cathode electrode;
an anode reflective electrode layer disposed on the anode electrode;
a cathode reflective electrode layer disposed on the cathode electrode;
a light emitting element including a first element electrode and a second element electrode;
an anode transparent electrode layer electrically connecting the anode reflective electrode layer and the first element electrode to each other; and
a cathode transparent electrode layer electrically connecting the cathode reflective electrode layer and the second element electrode to each other.

2. The display device of claim 1, wherein
the cathode electrode includes a base cathode electrode and a bridge cathode electrode, which are integral with each other, and
the base cathode electrode covers an area wider than an area which the bridge cathode electrode covers, and overlaps the light emitting element in a plan view.

3. The display device of claim 2, comprising sub-pixels, wherein
the base cathode electrode extends throughout the sub-pixels in a first direction,
the anode electrode includes a plurality of anode electrodes respectively corresponding to the sub-pixels, and
the bridge cathode electrode extends in a second direction different from the first direction, and is disposed between the plurality of anode electrodes in the first direction.

4. The display device of claim 1, wherein the anode electrode and the cathode electrode are formed as a same layer, and include a same conductive material.

5. The display device of claim 2, further comprising:
a bank covering a portion of each of the anode electrode and the cathode electrode, the bank having an opening, wherein
the bank exposes a portion of the base cathode electrode, and
the base cathode electrode and the cathode reflective electrode layer are in contact with each other at the portion of the base cathode electrode, which the bank exposes.

6. The display device of claim 5, wherein
the base cathode electrode and the cathode reflective electrode layer are electrically connected to each other at a cathode contact surface, and
in a plan view, the cathode contact surface overlaps the light emitting element such that the cathode reflective electrode layer forms a reflective surface for the light emitting element.

7. The display device of claim 6, wherein the cathode contact surface entirely covers the light emitting element in a plan view.

8. The display device of claim 5, wherein the anode reflective electrode layer is not disposed on an inner side surface of the bank, which faces the opening.

9. The display device of claim 1, wherein the cathode reflective electrode layer and the anode reflective electrode layer are formed as a same layer, and include a same reflective conductive material.

10. The display device of claim 1, wherein the cathode transparent electrode layer and the anode transparent electrode layer are formed as a same layer, and include a same transparent conductive material.

11. The display device of claim 1, wherein
the display element layer is disposed on the substrate in an upper direction of the substrate,
the light emitting element includes a first element electrode and a second element electrode, which face the upper direction,
the anode transparent electrode layer overlaps the first element electrode in a plan view, and
the cathode transparent electrode layer overlaps the second element electrode in a plan view.

12. The display device of claim 11, wherein
in a plan view, the cathode transparent electrode layer overlaps the cathode reflective electrode layer, and does not overlap the anode reflective electrode layer, and
in a plan view, the anode transparent electrode layer overlaps the cathode reflective electrode layer and the anode reflective electrode layer.

13. The display device of claim 5, further comprising:
an intermediate insulating layer disposed in the opening, the intermediate insulating layer being directly adjacent to the light emitting element.

14. The display device of claim 13, wherein the anode transparent electrode layer and the cathode transparent electrode layer are directly disposed on the intermediate insulating layer.

15. The display device of claim 14, wherein a difference between a height of a corner portion of the light emitting element and a maximum height of the intermediate insulating layer is smaller than a minimum thickness of the anode transparent electrode layer and the cathode transparent electrode layer.

16. The display device of claim 1, further comprising:
a capping layer covering the anode transparent electrode layer, the cathode transparent electrode layer, and the light emitting element.

17. The display device of claim 1, further comprising:
an identification pattern formed in at least one of the cathode electrode and the cathode reflective electrode layer.

18. The display device of claim 17, wherein the identification pattern includes an engraved pattern or an embossed pattern.

19. The display device of claim 1, wherein
the anode electrode is in contact with the anode reflective electrode layer at an anode contact surface,
the cathode electrode is in contact with the cathode reflective electrode layer at a cathode contact surface, and
the anode contact surface entirely overlaps the light emitting element in a plan view.

20. A method of manufacturing a display device, the method comprising:
manufacturing a pixel circuit layer disposed on a substrate; and
manufacturing a display element layer on the pixel circuit layer,
wherein the manufacturing the display element layer includes:
patterning an anode electrode and a cathode electrode on the pixel circuit layer;
patterning a bank to form an opening;
patterning a reflective electrode layer, the reflective electrode layer including:
a cathode reflective electrode layer electrically connected to the anode electrode, and
an anode reflective electrode layer electrically connected to the cathode electrode;
patterning an intermediate insulating layer disposed in the opening;
disposing a light emitting element in the opening; and
patterning a transparent electrode layer including a cathode transparent electrode layer electrically connected to the cathode reflective electrode layer and an anode transparent electrode layer electrically connected to the anode reflective electrode layer.

21. The method of claim 20, wherein
the cathode electrode includes a base cathode electrode and a bridge cathode electrode, which are integral with each other, and
the base cathode electrode covers an area wider than an area which the bridge cathode electrode covers, and overlaps the light emitting element in a plan view.

22. The method of claim 21, wherein
the base cathode electrode and the cathode reflective electrode layer are electrically connected to each other at a cathode contact surface, and
in a plan view, the cathode contact surface entirely covers the light emitting element such that the cathode reflective electrode layer forms a reflective surface for the light emitting element.

23. The method of claim 20, wherein the patterning of the intermediate insulating layer includes:
providing the intermediate insulating layer in the opening; and
etching a portion of the intermediate insulating layer, using a halftone mask.

24. The method of claim 20, wherein
the light emitting element includes a lateral chip type light emitting element, and
the patterning of the transparent electrode layer includes disposing the anode transparent electrode layer and the cathode transparent electrode layer to be directly adjacent to the intermediate insulating layer.
